(19) Europäisches Patentamt
European Patent Office
Office européen des brevets

(11) EP 2 061 103 A1

(12) **EUROPEAN PATENT APPLICATION**
published in accordance with Art. 153(4) EPC

(43) Date of publication:
**20.05.2009 Bulletin 2009/21**

(21) Application number: **07792550.1**

(22) Date of filing: **15.08.2007**

(51) Int Cl.:
***H01L 51/50*** *(2006.01)* ***C09K 11/06*** *(2006.01)*
***H05B 33/12*** *(2006.01)*

(86) International application number:
**PCT/JP2007/065916**

(87) International publication number:
**WO 2008/023623 (28.02.2008 Gazette 2008/09)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **22.08.2006 JP 2006224958**
**15.09.2006 US 521317**

(71) Applicant: **Idemitsu Kosan Co., Ltd.**
**Chiyoda-ku**
**Tokyo 100-8321 (JP)**

(72) Inventors:
- **JINDE, Yukitoshi**
**Chiba 299-0293 (JP)**
- **YABUNOUCHI, Nobuhiro**
**Chiba 299-0293 (JP)**
- **KUMA, Hitoshi**
**Chiba 299-0293 (JP)**
- **HOSOKAWA, Chishio**
**Chiba 299-0293 (JP)**

(74) Representative: **Gille Hrabal Struck Neidlein Prop Roos**
**Brucknerstraße 20**
**40593 Düsseldorf (DE)**

(54) **ORGANIC ELECTROLUMINESCENT DEVICE**

(57) An organic electroluminescent device (10) including:
an anode (1), a first emitting layer (3), a carrier blocking layer (4), a second emitting layer (5) and a cathode (7) in that order; the carrier blocking layer (4) including an aromatic amine derivative having a glass transition temperature of more than 110°C represented by the following formula (1);

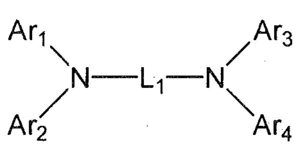

(1)

wherein $L_1$ is a divalent group of a substituted or unsubstituted arylene group with 5 to 60 carbon atoms, or a substituted or unsubstituted heterocyclic group;
$Ar_1$ is a substituted or unsubstituted substituent with 10 to 50 ring atoms, or a certain substituent; and $Ar_2$ to $Ar_4$ are each a substituted or unsubstituted substituent with 5 to 50 ring atoms or a certain substituent, provided that $Ar_1$ to $Ar_4$ are not condensed rings.

FIG.1

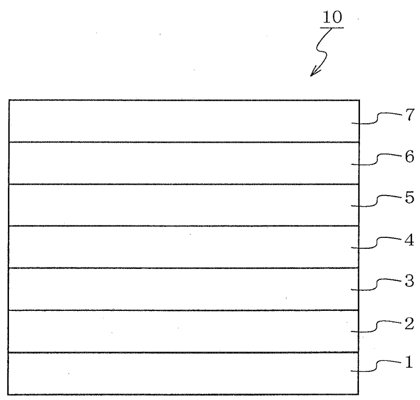


EP 2 061 103 A1

**Description**

Technical Field

The invention relates to an organic electroluminescent device.

Technical Background

Recently, white organic electroluminescent (EL) devices are being actively developed because they can be used for a mono-color display device, a lighting application such as a back light, and a full-color display with color filters. In the case where white organic EL devices are used for lighting applications, they are required to have a high luminous efficiency, for example, which is equivalent to or more than that of fluorescent lamps.

Many methods of producing white light emission by an organic EL device have been disclosed. Few of the methods produce white light with only one kind of emitting material and a single organic EL device generally uses two or three kinds of emitting materials that emit light simultaneously. In the case of using two kinds of emitting materials, a blue emitting material and a yellow-to-red emitting material, yellow-to-red being the complementary color to blue, are selected. However, the yellow-to-red light emission becomes dominant in many cases, thereby yielding a reddish white color.

Patent document 1 proposes a white device in the type where an emitting layer is divided into two layers, the emission zone of which tends to be localized to the anode side. The tendency for red to be strong in color of emitted light is negated by using a blue emitting layer as an emitting layer on the anode side, and whose color change is suppressed. However, the lifetime was 10,000 hours under constant current drive at an initial luminance of 1,000 cd/$m^2$.

Patent document 2 discloses an organic EL device in which a red emitting layer, a blue emitting layer, and a green emitting layer are stacked in that order from the anode side. The patent document 2 also discloses technology of reducing a change in color due to an increase in driving current by doping the blue emitting layer with a red dopant used for the red emitting layer. However, the lifetime was short.

As technology of obtaining white light in a well-balanced manner, technologies of providing a carrier blocking layer between emitting layers have been disclosed.

For example, patent document 3 discloses an organic EL device which emits white light and in which an anode, a hole transporting blue emitting layer, an electron transporting carrier recombination zone control layer, an electron transporting red emitting layer, and a cathode are stacked in that order. However, since the affinity level of the carrier recombination zone control layer is larger than the affinity level of the hole transporting blue emitting layer, the organic EL device requires a high driving voltage. Moreover, since electrons are injected into the hole transporting blue emitting layer to a smaller extent as the driving time increases, the emission intensity of the hole transporting red emitting layer decreases, whereby the emission color tends to be biased to the red light from the electron transporting emitting layer, and the lifetime is short.

Patent document 4 discloses a white organic EL device in which two electron transporting emitting layers are disposed through a carrier blocking layer. However, since holes injected from the anode are almost completely consumed by the first emitting layer, only a small number of holes are supplied to the second electron transporting emitting layer through the carrier blocking layer. As a result, white luminous efficiency is decreased, and the lifetime is short.

Patent document 5 discloses a white organic EL device in which an anode, first emitting layer, carrier blocking layer, second emitting layer, and cathode are stacked in that order, wherein the ionization potential of the carrier blocking layer is greater than the ionization potential of the first emitting layer in an amount of 0.1 eV or more, and the affinity level of the carrier blocking layer is smaller than the affinity level of the second emitting layer in an amount of 0.1 eV or more. However, since the carrier blocking layer has functions of both an electron barrier and a hole barrier, the driving voltage is increased. The lifetime was 10,000 hours under constant current drive at an initial luminance of 1,000 cd/$m^2$.

Patent document 6 discloses an organic EL device in which a red emitting layer, a green emitting layer, and a blue emitting layer are stacked in that order from the anode side, and a hole transporting and electron blocking intermediate layer is provided at least between the green emitting layer and the blue emitting layer. However, this organic EL device exhibits an insufficient luminous efficiency.

Patent document 7 discloses an organic EL device using a naphthacene derivative and a periflanthene derivative. However, this organic EL device exhibits an insufficient luminous efficiency.

[Patent document 1] JP-A-2003-272857
[Patent document 2] JP-A-2004-235168
[Patent document 3] JP-A-8-78163
[Patent document 4] WO2005/099313

[Patent document 5] WO2005/112518
[Patent document 6] JP-A-2005-100921
[Patent document 7] US-A-2006/0088729

Disclosure of the Invention

In a known white device, a carrier blocking layer is provided in order to adjust the amount of electrons and holes injected into two emitting layers, as described above. When causing such a white device to emit light for a long time, the carrier blocking layer repeatedly undergoes oxidation and reduction due to electron and hole movement to generate heat. This causes the material to deteriorate, thereby decreasing the lifetime.
In view of the above-described problem, an object of the invention is to provide an organic EL device which exhibits a long lifetime suitable for display and lighting applications, exhibits excellent color rendition and luminous efficiency, and shows only a small change in chromaticity.
The inventors of the invention have conducted extensive studies in order to achieve the above object. As a result, the inventors found that a specific material exhibits resistance to electron and hole movement and high heat resistance, and an organic EL device, which has a long lifetime, exhibits excellent color rendition and luminous efficiency, and shows only a small change in chromaticity, can be obtained by using the above material. This finding has led to the completion of the invention.
According to the invention, the following organic EL device is provided.

1. An organic electroluminescent device comprising: an anode, a first emitting layer, a carrier blocking layer, a second emitting layer and a cathode in that order; the carrier blocking layer comprising an aromatic amine derivative having a glass transition temperature of more than 110°C represented by the following formula (1);

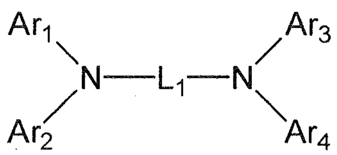

(1)

wherein $L_1$ is a divalent group of a substituted or unsubstituted arylene group with 5 to 60 carbon atoms, or a substituted or unsubstituted heterocyclic group;
$Ar_1$ is a substituted or unsubstituted substituent with 10 to 50 atoms that form a ring (ring atoms), or a substituent represented by the following formula (2); and
$Ar_2$ to $Ar_4$ are each a substituted or unsubstituted substituent with 5 to 50 ring atoms or a substituent represented by the following formula (2), provided that $Ar_1$ to $Ar_4$ are not condensed rings;

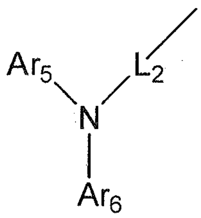

(2)

wherein $L_2$ is a divalent group of a substituted or unsubstituted arylene group with 5 to 60 carbon atoms or a substituted or unsubstituted heterocyclic group, and
$Ar_5$ to $Ar_6$ are each a substituted or unsubstituted substituent with 5 to 50 ring atoms, provided that $Ar_5$ to $Ar_6$ are not condensed rings.
2. The organic electroluminescent device according to 1 wherein $L_1$ and $L_2$ are biphenylene, terphenylene, phenanthrene or a substituted or unsubstituted fluorenylene in the formula (1).
3. The organic electroluminescent device according to 1 or 2 wherein $Ar_1$ is a biphenyl group, m-terphenyl group, or p-terphenyl group; and $Ar_2$ to $Ar_6$ are a phenyl group, biphenyl group, m-terphenyl group, or p-terphenyl group in the formula (1).

4. The organic electroluminescent device according to any one of 1 to 3 wherein $Ar_1$ to $Ar_4$ are the same substituents in the formula (1).
5. The organic electroluminescent device according to any one of 1 to 3 wherein $Ar_2$ to $Ar_4$ of $Ar_1$ to $Ar_4$ are the same substituents in the formula (1).
6. The organic electroluminescent device according to any one of 1 to 3 wherein 3 or more of $Ar_1$ to $Ar_4$ are different substituents in the formula (1).
7. The organic electroluminescent device according to any one of 1 to 6 wherein the carrier blocking layer comprises an emitting material.
8. The organic electroluminescent device according to any one of 1 to 7 further comprising a hole transporting layer adjacent to the first emitting layer between the anode and the first emitting layer, a material forming the hole transporting layer being the same as a material forming the carrier blocking layer.
9. The organic electroluminescent device according to any one of 1 to 8 wherein the first emitting layer is a red emitting layer and the second emitting layer is a blue emitting layer.
10. The organic electroluminescent device according to any one of 1 to 9 further comprising a third emitting layer between the second emitting layer and the cathode, the anode, first emitting layer, carrier blocking layer, second emitting layer, third emitting layer and cathode being stacked in that order.
11. The organic electroluminescent device according to 10 wherein the first emitting layer is a red emitting layer, the second emitting layer is a blue emitting layer and the third emitting layer is a green emitting layer.
12. The organic electroluminescent device according to any one of 1 to 11 wherein the first emitting layer or a first organic layer that is the organic layer closer to the anode comprises an oxidizing agent.
13. The organic electroluminescent device according to any one of 1 to 12 wherein the second emitting layer or a second organic layer that is the organic layer closer to the cathode comprises a reducing agent.
14. A full-color light-emitting apparatus comprising the organic electroluminescent device according to any one of 1 to 13 and a color filter.

According to the invention, an organic EL device can be provided which has a long lifetime, exhibits color rendition and high luminous efficiency, and shows only a small change in chromaticity.

FIG. 1 is a view showing a configuration of an organic EL device according to an embodiment of the invention.
FIG. 2 is a view showing a configuration of an organic EL device according to another embodiment of the invention.
FIG. 3 is a graph showing changes in luminance with time of organic EL devices fabricated in Example 2 and Comparative examples 3 and 4.

Best Mode for Carrying out the Invention

An organic EL device according to the invention includes an anode, a first emitting layer, a carrier blocking layer, a second emitting layer, and a cathode stacked in that order. The amount of electrons and holes injected into the first emitting layer and the second emitting layer can be adjusted by inserting the carrier blocking layer, whereby the luminous intensity of the first emitting layer and the second emitting layer can be adjusted. The carrier blocking layer exhibiting resistance to electron and hole movement due to long-time current driving and heat resistance includes an aromatic amine derivative of the following formula (1) which has a glass transition temperature higher than 110°C and in which a condensed ring is not directly coordinated to nitrogen.

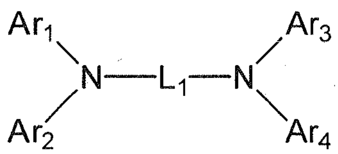
(1)

wherein $L_1$ is a divalent group selected from substituted or unsubstituted arylene groups having 5 to 60 carbon atoms or substituted or unsubstituted heterocyclic groups, $Ar_1$ is a substituted or unsubstituted substituent having 10 to 50 ring atoms or a substituent of the following formula (2), and $Ar_2$ to $Ar_4$ are individually a substituted or unsubstituted substituent having 5 to 50 ring atoms or a substituent of the following formula (2), provided that $Ar_1$ to $Ar_4$ are not condensed rings.

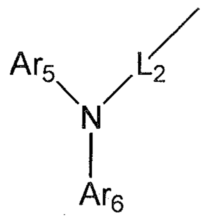

(2)

wherein $L_2$ is a divalent group selected from substituted or unsubstituted arylene groups having 5 to 60 carbon atoms or heterocyclic groups, and $Ar_5$ and $Ar_6$ are individually substituted or unsubstituted substituents having 5 to 50 ring atoms, provided that $Ar_5$ and $Ar_6$ are not condensed rings.

According to the invention, the above configuration provides a white organic EL device which has a long lifetime. The device of the invention exhibits color rendition and high luminous efficiency and shows only a small change in chromaticity even if the driving conditions (luminous efficiency and so on) change.

FIG. 1 is a first embodiment of such an organic EL device. An organic EL device 10 has a structure in which an anode 1, a hole transporting layer 2, a first emitting layer 3, a carrier blocking layer 4, a second emitting layer 5, an electron transporting layer 6, and a cathode 7 are stacked.

The carrier blocking layer 4 contains the above aromatic amine derivative.

The device 10 can emit white light by allowing the first emitting layer 3 to emit red light and the second emitting layer 5 to emit blue light, for example.

The device configuration according to this embodiment is not limited to the configuration shown in FIG. 1. For example, the following configurations may also be employed.

1. Anode/first emitting layer/carrier blocking layer/second emitting layer/cathode
2. Anode/hole transporting layer/first emitting layer/carrier blocking layer/second emitting layer/cathode
3. Anode/first emitting layer/carrier blocking layer/second emitting layer/electron transporting layer/cathode
4. Anode/hole transporting layer/first emitting layer/carrier blocking layer/second emitting layer/electron transporting layer/cathode
5. Anode/hole injecting layer/hole transporting layer/first emitting layer/carrier blocking layer/second emitting layer/electron transporting layer/cathode
6. Anode/hole injecting layer/hole transporting layer/first emitting layer/carrier blocking layer/second emitting layer/electron transporting layer/electron injecting layer/cathode

In these configurations, a hole transporting layer is preferably provided between an anode and a first emitting layer to prevent non-luminescent energy loss due to transfer of excitation energy caused by recombination of electrons and holes in a first emitting layer to an anode which shows a metallic behavior.

In the hole-transporting-layer-containing configuration, a material forming a hole transporting layer is preferably the same as a material forming a carrier blocking layer since the kinds of materials used for fabricating an organic EL device can be reduced with an advantageous cost for industrial production.

Another organic layer or inorganic layer may be inserted in addition to the above layers. The inserted layer is not limited insofar as the layer can transport electrons and holes. When the inserted layer is provided in the light-outcoupling direction, the layer is preferably transparent.

In the organic EL device of the invention, the first emitting layer or a first organic layer that is the organic layer closer to the anode preferably comprises an oxidizing agent for easier hole transfer, and lower voltage, higher efficiency and longer lifetime of the organic EL device. The second emitting layer or a second organic layer that is the organic layer closer to the cathode preferably comprises a reducing agent for easier electron transfer, and lower voltage, higher efficiency and longer lifetime of the organic EL device.

A plurality of carrier blocking layers may be stacked.

The organic EL device of the invention may further comprise a third emitting layer between the second emitting layer and the cathode, and the anode, the first emitting layer, the carrier blocking layer, the second emitting layer, the third emitting layer, and the cathode may be stacked in that order.

FIG. 2 is a view showing an embodiment of such an organic EL device. This organic EL device 20 has a structure in which the anode 1, the hole transporting layer 2, the first emitting layer 3, the carrier blocking layer 4, the second emitting layer 5, a third emitting layer 8, the electron transporting layer 6, and the cathode 7 are stacked. Specifically, the organic EL device 20 has the same configuration as that of the organic EL device 10 shown in FIG. 1 except that the third emitting layer 8 is additionally formed. Description of the same configuration is omitted.

The device 20 can emit white light with more excellent color rendition by allowing the first emitting layer 3 to emit red

light, the second emitting layer 5 to emit blue light, and the third emitting layer 8 to emit green light, for example.

At this time, the first emitting layer preferably comprises a hole transporting material, and the second emitting layer and third emitting layer preferably comprise an electron transporting material. This allows efficient recombination of holes and electrons in the first and second emitting layers on both the sides of the carrier blocking layer, thereby obtaining white emission excellent in luminous efficiency.

The device configuration is not limited to the configuration shown in FIG. 2. For example, configurations in which a third emitting layer is formed in the device configurations 1 to 6 described above may be employed, or a plurality of carrier blocking layers may be stacked.

Members such as the carrier blocking layer, the first emitting layer, the second emitting layer, and the third emitting layer will be described below.

1. Carrier blocking layer

The carrier blocking layer includes an aromatic amine derivative of the following formula (1) which exhibits resistance to electron and hole movement and heat resistance and has a glass transition temperature higher than 110°C. The glass transition temperature is a temperature which represents the heat resistance of the material.

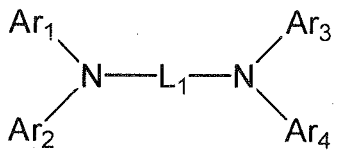

(1)

wherein $L_1$ is a divalent group selected from substituted or unsubstituted arylene groups having 5 to 60 carbon atoms or heterocyclic groups, $Ar_1$ is a substituted or unsubstituted substituent having 10 to 50 ring atoms or a substituent of the following formula (2), and $Ar_2$ to $Ar_4$ are individually a substituted or unsubstituted substituent having 5 to 50 ring atoms or a substituent of the following formula (2), provided that $Ar_1$ to $Ar_4$ are not condensed rings.

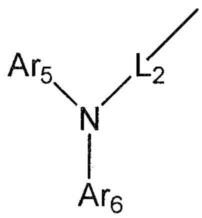

(2)

wherein $L_2$ is a divalent group selected from substituted or unsubstituted arylene groups having 5 to 60 carbon atoms or heterocyclic groups, and $Ar_5$ and $Ar_6$ are individually substituted or unsubstituted substituents having 5 to 50 ring atoms, provided that $Ar_5$ and $Ar_6$ are not condensed rings.

As examples of $L_1$ and $L_2$, biphenylene, terphenylene, phenanthrene, or substituted or unsubstituted fluorenylene can be given. Of these, biphenylene or terphenylene is preferable, with biphenylene being still more preferable.

A substituent of the above substituted fluorenylene is preferably an alkyl group having carbon atoms 1 to 4, more preferably a methyl group.

$Ar_1$ is preferably a phenyl, biphenyl, m-terphenyl or p-terphenyl group.

$Ar_2$ to $Ar_6$ are preferably a phenyl, biphenyl, m-terphenyl or p-terphenyl group.

Substutuents of $Ar_1$ to $Ar_6$ include a naphthyl group.

In the compound of the formula (1), it is preferable that $Ar_1$ to $Ar_4$ be identical substituents. In this case, $Ar_1$ to $Ar_4$ are preferably biphenyl groups or terphenyl groups, and still more preferably biphenyl groups.

In the compound of the formula (1), it is also preferable that $Ar_2$ to $Ar_4$ among $Ar_1$ to $Ar_4$ be identical substituents. In this case, $Ar_1$ is a biphenyl group, an m-terphenyl group, a p-terphenyl group, or a phenyl group, and preferably a biphenyl group, an m-terphenyl group, a p-terphenyl group, or a phenyl group. $Ar_2$ to $Ar_4$ are preferably phenyl groups, biphenyl groups, m-terphenyl groups, or p-terphenyl groups, and more preferably biphenyl groups. It is still more preferable that $Ar_1$ be an m-terphenyl group or a p-terphenyl group and $Ar_2$ to $Ar_4$ be biphenyl.

In the compound of the formula (1), it is also preferable that three or more of $Ar_1$ to $Ar_4$ be different substituents. In this case, $Ar_1$ to $Ar_4$ are preferably a biphenyl group, an m-terphenyl group, a p-terphenyl group, or a phenyl group, and more preferably a biphenyl group, an m-terphenyl group, a p-terphenyl group, or a phenyl group. It is still more preferable that $Ar_3$ and $Ar_4$ be biphenyl, $Ar_1$ be an m-terphenyl group or a p-terphenyl group, and $Ar_2$ be phenyl.

Specific examples of the aromatic amine derivative which may be used in the invention are given below.

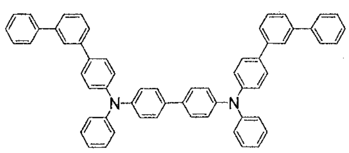

A－1

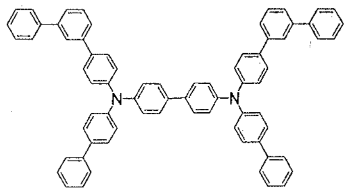

A－2

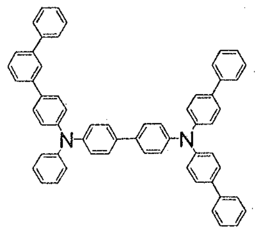

A－3

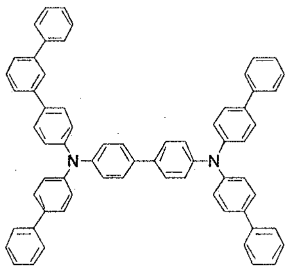

A－4

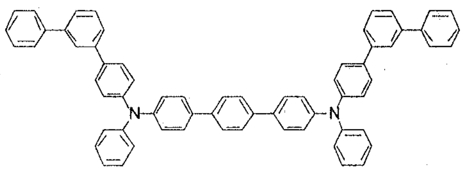

A－5

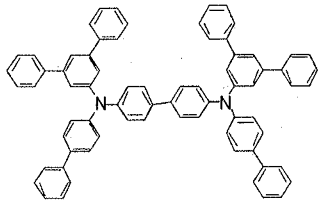

A－6

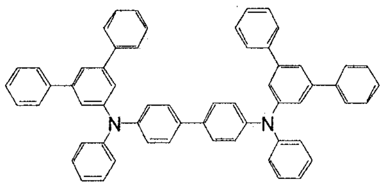

A－7

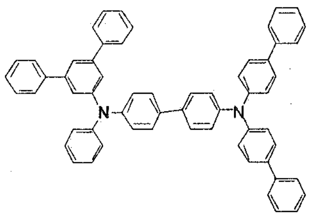

A－8

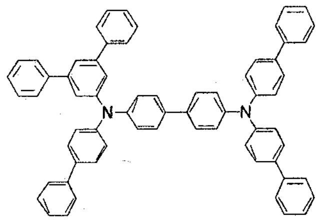

A－9

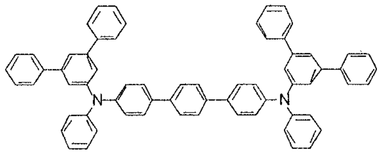

A-10

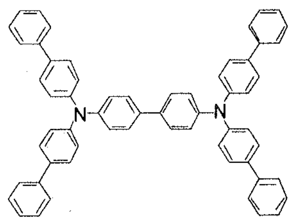

A-11

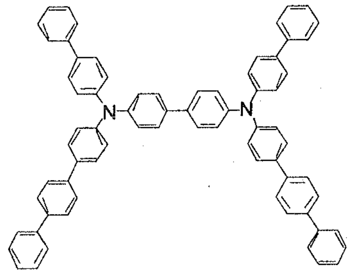

A-12

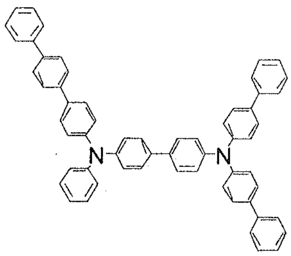

A-13

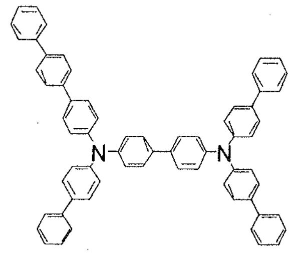

A-14

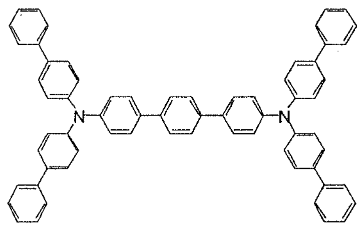

A-15

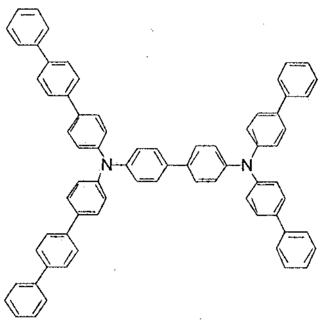

A-16

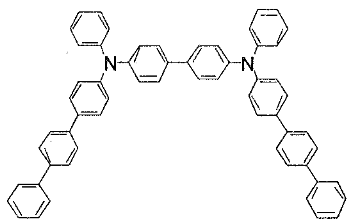

A-17

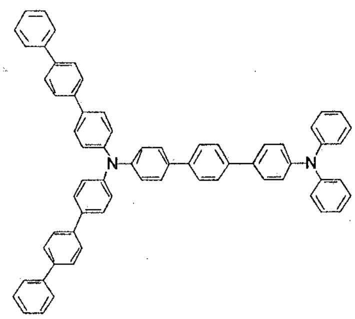

A-18

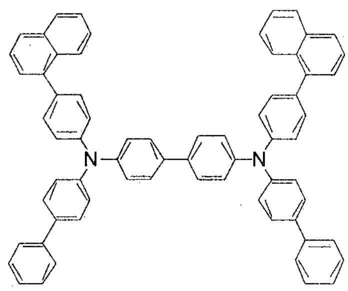

A－１９

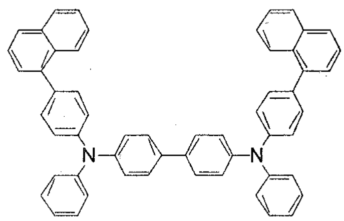

A－２０

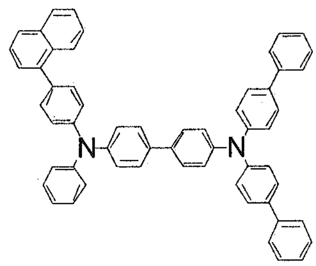

A－２１

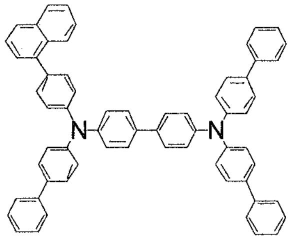

A－２２

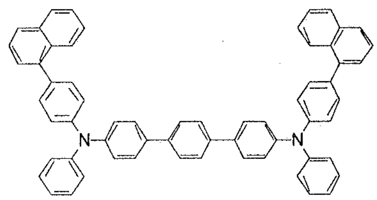

A－２３

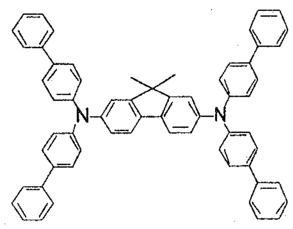

A－２４

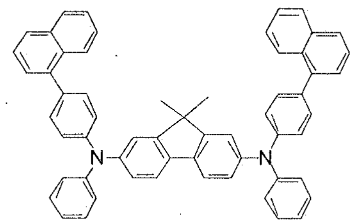

A－２５

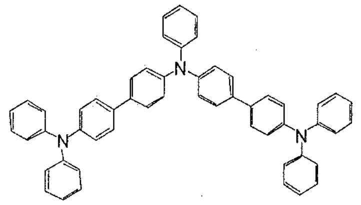

A－２６

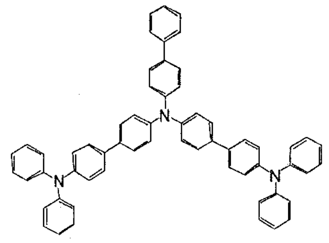

A－２７

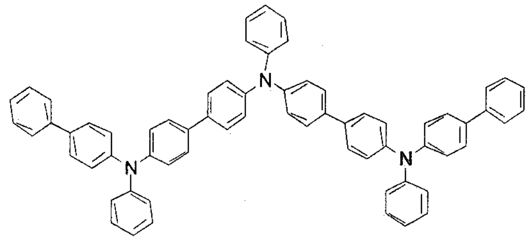

A－２８

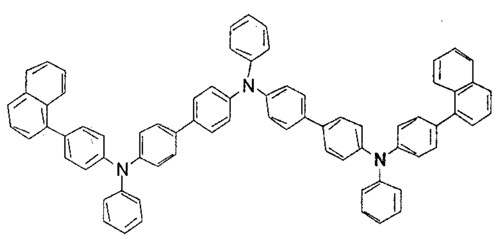

A－２９

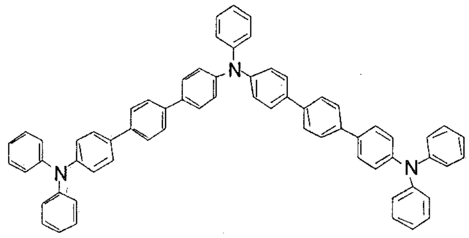

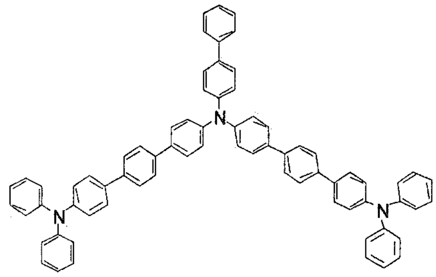

A－３０　　A－３１

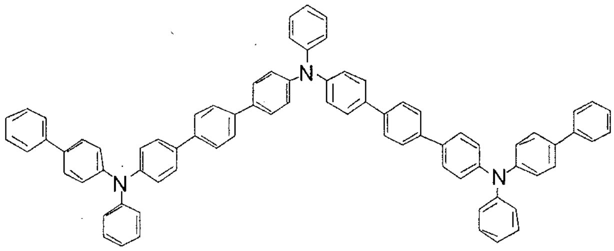

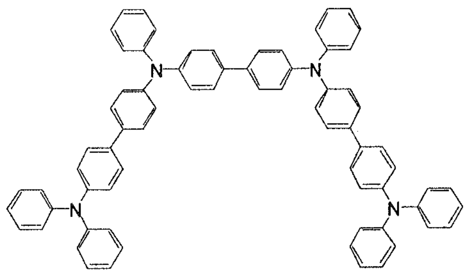

A－３２　　A－３３

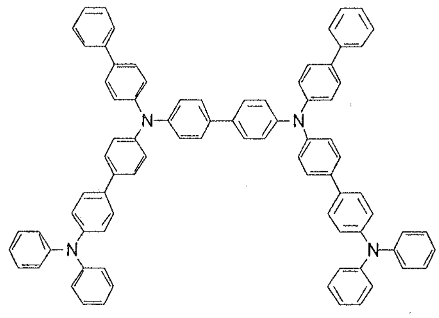

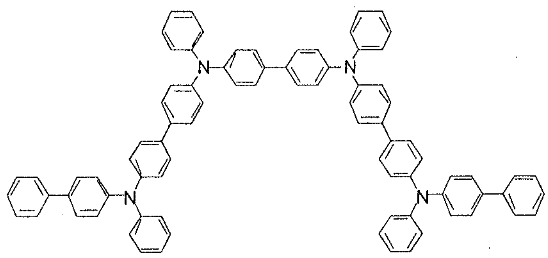

A－３４　　A－３５

The thickness of the carrier blocking layer is preferably 0.1 to 50 nm, although the thickness is not particularly limited. The thickness is more preferably 0.1 to 20 nm.

A luminescent material may be added to the carrier blocking layer. This ensures emission of light containing a wider variety of components. For example, white light with higher color rendition can be obtained. As the luminescent material, a dopant or the like used for each emitting layer described later may be used.

2. First emitting layer

The emitting layer of the organic EL device has the following functions in combination.

(1) Injection function: function of allowing injection of holes from the anode or hole injecting/transporting layer and injection of electrons from the cathode or electron injecting/transporting layer upon application of an electric field
(2) Transporting function: function of moving injected carriers (electrons and holes) due to the force of an electric field
(3) Emitting function: function of allowing electrons and holes to recombine to emit light

Note that electrons and holes may be injected into the emitting layer at different degrees, or the transportation capabilities represented by the mobility of holes and electrons may differ. It is preferable that the emitting layer move either electrons or holes.

As the method of forming the emitting layer, a known method such as deposition, spin coating, or an LB method may be applied. It is preferable that the emitting layer be a molecular deposition film.

The term "molecular deposition film" refers to a thin film formed by depositing a vapor-phase material compound or a film formed by solidifying a solution-state or liquid-phase material compound. The molecular deposition film is distinguished from a thin film (molecular built-up film) formed using the LB method by the difference in aggregation structure or higher order structure or the difference in function caused by the difference in structure.

The emitting layer may also be formed by dissolving a binder such as a resin and a material compound in a solvent to obtain a solution, and forming a thin film by spin coating or the like of the solution, as disclosed in JP-A-57-51781.

As the material used for the first emitting layer, a known long-lived luminescent material may be used. It is preferable to use a material of the formula (3) as the luminescent material.

$$(Ar')_m-(X')_n \qquad (3)$$

wherein Ar' is an aromatic ring having 6 to 50 ring carbon atoms or a heteroaromatic ring having 5 to 50 ring atoms.

As specific examples of Ar', a phenyl ring, a naphthyl ring, an anthracene ring, a biphenylene ring, an azulene ring, an acenaphthylene ring, a fluorene ring, a phenanthrene ring, a fluoranthene ring, an aceanthrylene ring, a triphenylene ring, a pyrene ring, a chrysene ring, a benzanthracene ring, a naphthacene ring, a picene ring, a perylene ring, a pentaphene ring, a pentacene ring, a tetraphenylene ring, a hexaphene ring, a hexacene ring, a rubicene ring, a coronene ring, a trinaphthylene ring, a pyrrole ring, an indole ring, a carbazole ring, an imidazole ring, a benzimidazole ring, an oxadizole ring, a triazole ring, a pyridine ring, a quinoxaline ring, a quinoline ring, a pyrimidine ring, a triazine ring, a thiophene ring, a benzothiophene ring, a thianthrene ring, a furan ring, a benzofuran ring, a pyrazole ring, a pyrazine ring, a pyridazine ring, an indolizine ring, a quinazoline ring, a phenanthroline ring, a silole ring, a benzosilole ring, and the like can be given.

Ar' is preferably a phenyl ring, a naphthyl ring, an anthracene ring, an acenaphthylene ring, a fluorene ring, a phenanthrene ring, a fluoranthene ring, a triphenylene ring, a pyrene ring, a chrysene ring, a benzanthracene ring, or a perylene ring.

X' is a substituent.

In more detail, X' is a substituted or unsubstituted aromatic group having 6 to 50 ring carbon atoms, a substituted or unsubstituted aromatic heterocyclic group having 5 to 50 ring atoms, a substituted or unsubstituted alkyl group having 1 to 50 carbon atoms, a substituted or unsubstituted alkoxy group having 1 to 50 carbon atoms, a substituted or unsubstituted aralkyl group having 1 to 50 carbon atoms, a substituted or unsubstituted aryloxy group having 5 to 50 ring atoms, a substituted or unsubstituted arylthio group having 5 to 50 ring atoms, a substituted or unsubstituted carboxyl group having 1 to 50 carbon atoms, a substituted or unsubstituted styryl group, a halogen group, a cyano group, a nitro group, a hydroxyl group, or the like.

As examples of the substituted or unsubstituted aromatic group having 6 to 50 ring atoms, a phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, and 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4''-t-butyl-p-terphenyl-4-yl group, 2-fluorenyl group, 9,9-dimethyl-2-fluorenyl group, 3-fluoranthenyl group, and the like can be given.

The substituted or unsubstituted aromatic group having 6 to 50 ring atoms is preferably a phenyl group, 1-naphthyl group, 2-naphthyl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, o-tolyl group, m-tolyl group, p-tolyl group, p-t-butylphenyl group, 2-fluorenyl group, 9,9-dimethyl-2-fluorenyl group, 3-fluoranthenyl group, or the like.

As examples of the substituted or unsubstituted aromatic heterocyclic group having 5 to 50 ring atoms, a 1-pyrrolyl group, 2-pyrrolyl group, 3-pyrrolyl group, pyrazinyl group, 2-pyridinyl group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-isoindolyl group, 2-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-carbazolyl group, 2-carbazolyl group, 3-carbazolyl group, 4-carbazolyl group, 9-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiadinyl group, 2-phenothiadinyl group, 3-phenothiadinyl group, 4-phenothiadinyl group, 10-phenothiadinyl group, 1-phenoxadinyl group, 2-phenoxadinyl group, 3-phenoxadinyl group, 4-phenoxadinyl group, 10-phenoxadinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butyl-pyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group, 4-t-butyl-3-indolyl group, and the like can be given.

As examples of the substituted or unsubstituted alkyl group having 1 to 50 carbon atoms, a methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, 1,2,3-trinitropropyl group, cyclopropyl group, cyclobutyl group, cyclopentyl group, cyclohexyl group, 4-methylcyclohexyl group, 1-adamantyl group, 2-adamantyl group, 1-norbornyl group, 2-norbornyl group, and the like can be given.

The substituted or unsubstituted alkoxy group having 1 to 50 carbon atoms is a group shown by -OY. As examples of Y, a methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, 1,2,3-trinitropropyl group, and the like can be given.

As examples of the substituted or unsubstituted aralkyl group having 1 to 50 carbon atoms, a benzyl group, 1-phenylethyl group, 2-phenylethyl group, 1-phenylisopropyl group, 2-phenylisopropyl group, phenyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthylisopropyl group, 2-β-naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydroxybenzyl group, o-hydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylispropyl group, 1-chloro-2-phenylisopropyl group and the like can be given.

The substituted or unsubstituted aryloxy group having 5 to 50 ring atoms is shown by -OY'. As examples of Y', a phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4''-t-butyl-p-terphenyl-4-yl group, 2-pyrrolyl group, 3-pyrrolyl group, pyrazinyl group, 2-pyridinyl group, 3-pyridinyl group, 4-pyridinyl group, 2-indolyl group, 3-indolyl group, 4-indolyl group, 5-indolyl group, 6-indolyl group, 7-indolyl group, 1-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-carbazolyl group, 2-carbazolyl group, 3-carbazolyl group, 4-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiadinyl group, 2-phenothiadinyl group, 3-phenothiadinyl group, 4-phenothiadinyl group, 1-phenoxadinyl group, 2-phenoxadinyl group, 3-phenoxadinyl group, 4-phenoxadinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group, 4-t-butyl-3-indolyl group, and the like can be given.

The substituted or unsubstituted arylthio group having 5 to 50 ring atoms is shown by -SY''. As examples of Y'', a phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4''-t-butyl-p-terphenyl-4-yl group, 2-pyrrolyl group, 3-pyrrolyl group, pyrazinyl group, 2-pyridinyl group, 3-pyridinyl group, 4-pyridinyl group, 2-indolyl group, 3-indolyl group, 4-indolyl group, 5-indolyl group, 6-indolyl group, 7-indolyl group, 1-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-carbazolyl group, 2-carbazolyl group, 3-carbazolyl group, 4-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9 phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiadinyl group, 2-phenothiadinyl group, 3-phenothiadinyl group, 4-phenothiadinyl group, 1-phenoxadinyl group, 2-phenoxadinyl group, 3-phenoxadinyl group, 4-phenoxadinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butyl-pyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group, 4-t-butyl-3-indolyl group, and the like can be given.

The substituted or unsubstituted carboxyl group having 1 to 50 carbon atoms is shown by -COOZ'. As examples of Z', a methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, 1,2,3-trinitropropyl group, and the like can be given.

As examples of the substituted or unsubstituted styryl group, 2-phenyl-1-vinyl group, 2,2-diphenyl-1-vinyl group, 1,2,2-triphenyl-1-vinyl group, and the like can be given.

As examples of the halogen group, fluorine, chlorine, bromine, iodine, and the like can be given.

m is an integer of 1 to 5, and n is an integer of 0 to 6.
m is preferably 1 or 2, and n is preferably 0 to 4.

When $m \geq 2$, the Ar's in the parenthesis may be the same or different.
When $n \geq 2$, the X's in the parenthesis may be the same or different.

With regard to the emission color, it is preferable that the first emitting layer be a yellow-orange or red emitting layer. The yellow-orange or red emitting layer is an emitting layer having a maximum emission wavelength of 550 to 650 nm. The emitting layer preferably includes a host material and a yellow-orange or red dopant.

The host material of the first emitting layer of the organic EL device according to the invention preferably includes one or more compounds selected from a naphthacene derivative, a diaminoanthracene derivative, a naphthofluoranthene derivative, a diaminopyrene derivative, a diaminoperylene derivative, an aminoanthracene derivative, an aminopyrene derivative, and a dibenzochrysene derivative as the compound of the formula (3). The host material more preferably includes a naphthacene derivative.

The naphthacene derivative is shown by the following formula (4).

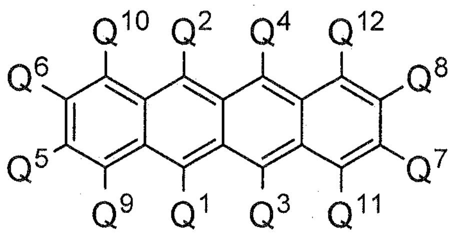

(4)

wherein $Q^1$ to $Q^{12}$, which may be the same or different, are independently a hydrogen atom, a substituted or unsubstituted alkyl group having 1 to 20 carbon atoms, a substituted or unsubstituted aryl group having 6 to 20 carbon atoms, an amino group, a substituted or unsubstituted alkoxy group having 1 to 20 carbon atoms, a substituted or unsubstituted alkylthio group having 1 to 20 carbon atoms, a substituted or unsubstituted aryloxy group having 6 to 20 ring carbon atoms, a substituted or unsubstituted arylthio group having 6 to 20 ring carbon atoms, a substituted or unsubstituted alkenyl group having 2 to 20 carbon atoms, a substituted or unsubstituted aralkyl group having 7 to 20 ring carbon atoms or a substituted or unsubstituted heterocyclic group having 5 to 20 ring atoms.

The naphthacene derivative represented by the formula (4) is more preferably one represented by the following formula (5).

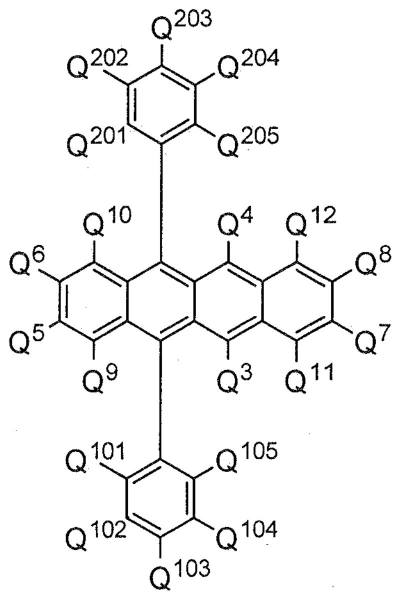

(5)

wherein $Q^3$ to $Q^{12}$, $Q^{101}$ to $Q^{105}$, and $Q^{201}$ to $Q^{205}$, which may be the same or different, are independently the same groups as those mentioned for $Q^3$ to $Q^{12}$ in the formula (4), and two or more adjacent groups thereof may be bonded to each other to form a ring.

There can be used as a yellow-to-orange or red dopant a fluorescent compound containing at least one of a

fluoranthene skeleton and a perylene skeleton. Examples thereof include compounds represented by the following formulas [6] to [22].

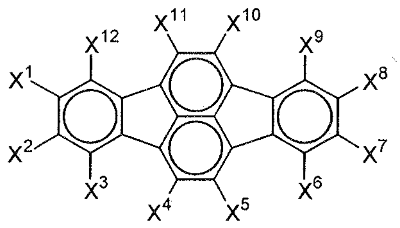

(6)

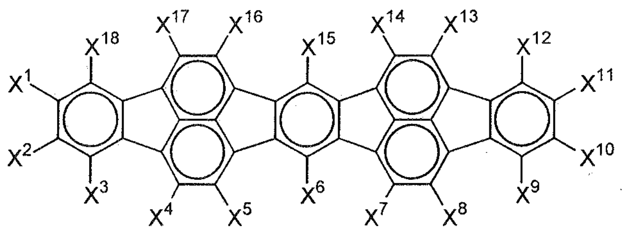

(7)

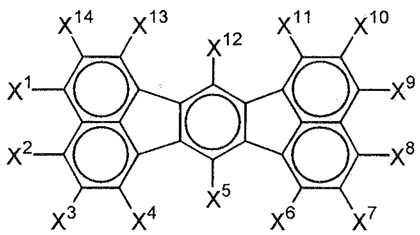

(8)

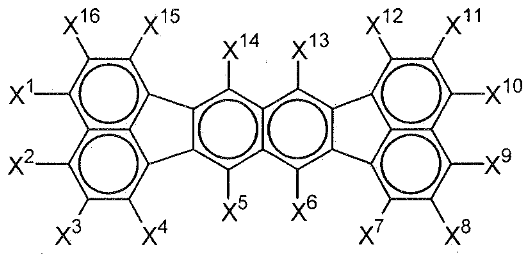

(9)

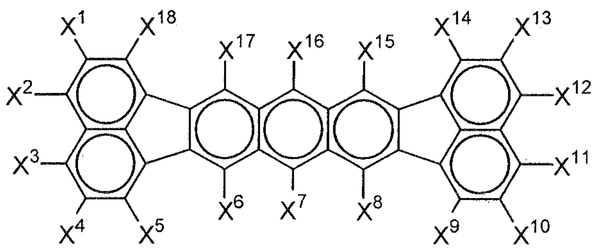

(10)

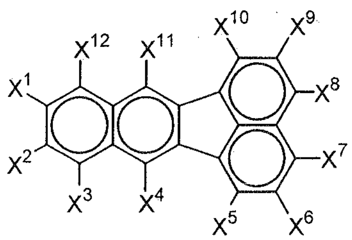

(11)

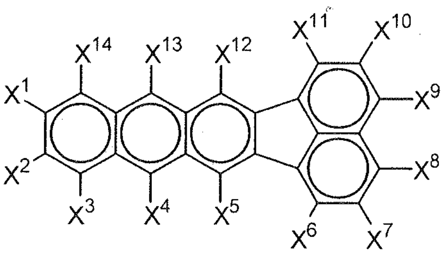

(12)

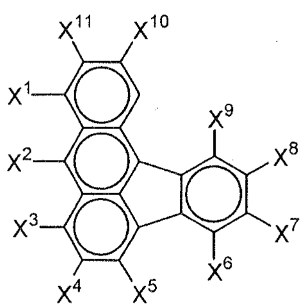

(13)

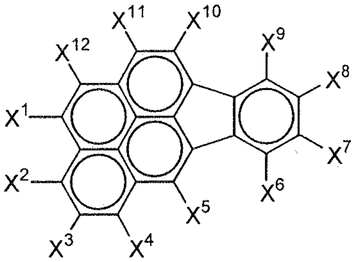

(1 4)

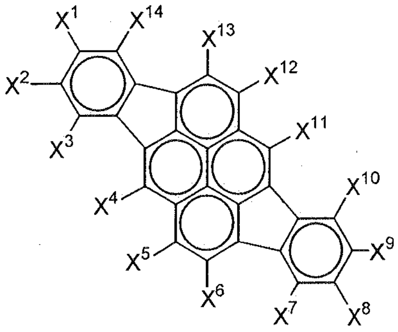

(1 5)

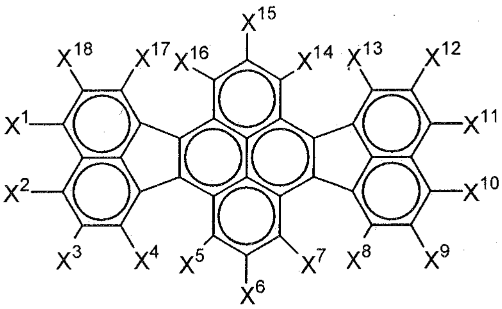

(1 6)

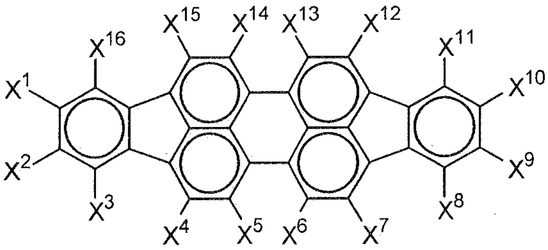

(1 7)

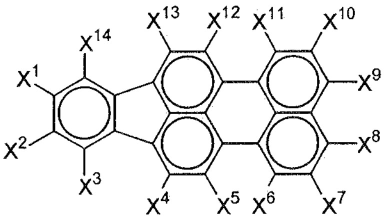

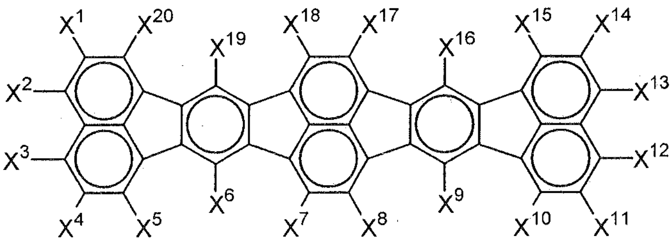

(1 8)

(1 9)

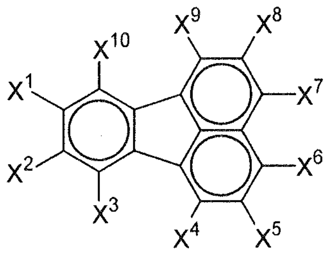
(20)

In the formulas (6) to (20), $X^1$ to $X^{20}$ are independently a hydrogen atom, a linear, branched or cyclic alkyl group with 1 to 20 carbon atoms, a linear, branched or cyclic alkoxy group with 1 to 20 carbon atoms, a substituted or unsubstituted aryl group with 6 to 30 carbon atoms, a substituted or unsubstituted aryloxy group with 6 to 30 carbon atoms, a substituted or unsubstituted arylamino group with 6 to 30 carbon atoms, a substituted or unsubstituted alkylamino group with 1 to 30 carbon atoms, a substituted or unsubstituted arylalkylamino group with 7 to 30 carbon atoms or a substituted or unsubstituted alkenyl group with 8 to 30 carbon atoms; adjacent substituents and $X^1$ to $X^{20}$ may be bonded together to form a ring structure; and when adjacent substituents are an aryl group, the substituents may be the same.
The compounds of the formulas (6) to (20) preferably contain an amino group or an alkenyl group.

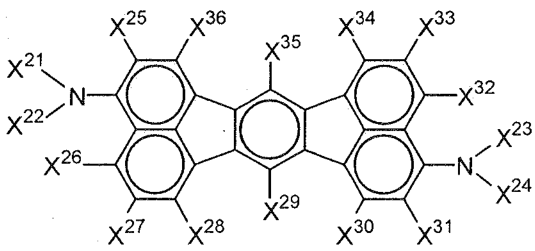
(21)

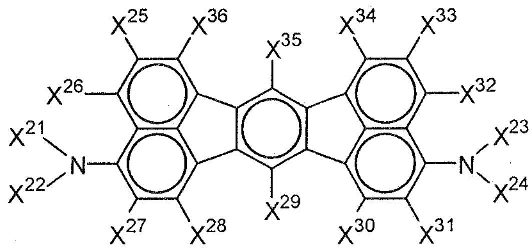
(22)

In the formulas (21) and (22), $X^{21}$ to $X^{24}$ are independently an alkyl group with 1 to 20 carbon atoms, a substituted or unsubstituted aryl group with 6 to 30 carbon atoms; $X^{21}$ and $X^{22}$ and/or $X^{23}$ and $X^{24}$ may be bonded to each other with a carbon to carbon bond, -O- or -S-therebetween;
$X^{25}$ to $X^{36}$ are independently a hydrogen atom, a linear, branched or cyclic alkyl group with 1 to 20 carbon atoms, a linear, branched or cyclic alkoxy group with 1 to 20 carbon atoms, a substituted or unsubstituted aryl group with 6 to 30 carbon atoms, a substituted or unsubstituted aryloxy group with 6 to 30 carbon atoms, a substituted or unsubstituted arylamino group with 6 to 30 carbon atoms, a substituted or unsubstituted alkylamino group with 1 to 30 carbon atoms, a substituted or unsubstituted arylalkylamino group with 7 to 30 carbon atoms or a substituted or unsubstituted alkenyl group with 8 to 30 carbon atoms; and adjacent substituents and $X^{25}$ to $X^{36}$ may be bonded together to form a ring structure.
At least one of the substituents $X^{25}$ to $X^{36}$ in each of the formulas preferably contains an amino or alkenyl group.

The compound containing a fluoranthene skeleton or a perylene skeleton is an indenoperylene derivative of the following formula (23) or (24).

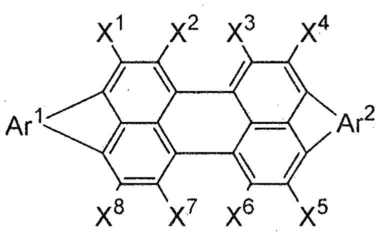
(23)

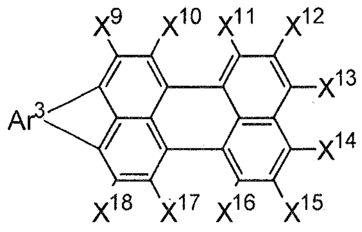
(24)

wherein $Ar^1$, $Ar^2$ and $Ar^3$ are each independently a substituted or unsubstituted aromatic ring group or aromatic heterocyclic group; $X^1$ to $X^{18}$ are each a hydrogen atom, halogen atom, alkyl group, alkoxy group, alkylthio group, alkenyl group, alkenyloxy group, alkenylthio group, aromatic-ring-containing alkyl group, aromatic-ring-containing alkyloxy group, aromatic-ring-containing alkylthio group, aromatic ring group, aromatic heterocyclic group, aromatic ring oxy group, aromatic ring thio group, aromatic ring alkenyl group, alkenyl aromatic ring group, amino group, carbazolyl group, cyano group, hydroxyl group, $-COOR^{1'}$ ($R^{1'}$ is a hydrogen atom, alkyl group, alkenyl group, aromatic-ring-containing alkyl group, or aromatic ring group), $-COR^{2'}$ ($R^{2'}$ is a hydrogen atom, alkyl group, alkenyl group, aromatic-ring-containing alkyl group, aromatic ring group or amino group) or $-OCOR^{3'}$ ($R^{3'}$ is an alkyl group, alkenyl group, aromatic-ring-containing alkyl group or aromatic ring group); and adjacent groups of $X^1$ to $X^{18}$ may be bonded to each other to form a ring with a substituted carbon atom.

A fluorescent compound containing a fluoranthene skeleton preferably contains an electron-donating group for high performance and long lifetime. A preferable electron-donating group is a substituted or unsubstituted arylamino group. A fluorescent compound containing a fluoranthene skeleton preferably has 5 or more fused rings, more preferably 6 or more fused rings, for the following reason. The fluorescent compound has a fluorescent peak wavelength of 540 to 700 nm. The emission from a blue emitting material and emission from the fluorescent compound overlap to give a white color.
The above-mentioned fluorescent compound preferably contains a plurality of fluoranthene skeletons since the emitted light color falls in the yellow-to-orange or red zone. A particularly preferred fluorescent compound contains an electron-donating group, and a fluoranthene skeleton or a perylene skeleton, and shows a fluorescent peak wavelength of 540 to 700 nm.

The thickness of a first emitting layer is preferably 1 to 60 nm, more preferably 5 to 30 nm and most preferably 5 to 20 nm. When it is less than 1 nm, the luminous efficiency may decrease. When it exceeds 60 nm, the driving voltage may increase.

3. Second emitting layer

In regard to the emission color, it is preferable that the second emitting layer be a blue emitting layer in view of energy gaps. The peak wavelength of the blue light is preferably 450 to 500 nm.

As the host material for use in the second emitting layer, compounds having a structure represented by the following formula (25), which has an anthracene main skeleton, are preferable.

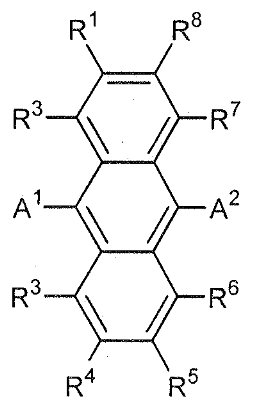

(25)

wherein $A^1$ and $A^2$ are independently a group derived from a substituted or unsubstituted aromatic ring having 6 to 20 ring carbon atoms.
The aromatic ring may be substituted with one or two or more substituents.
The substituent is selected from a substituted or unsubstituted aryl group having 6 to 50 ring carbon atoms, a substituted or unsubstituted alkyl group having 1 to 50 carbon atoms, a substituted or unsubstituted cycloalkyl group having 3 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 ring atoms, a substituted or unsubstituted arythio group having 5 to 50 ring atoms, a substituted or unsubstituted alkoxycarbonyl group having 1 to 50 carbon atoms, a substituted or unsubstituted silyl group, a carboxyl group, a halogen atom, a cyano group, a nitro group and a hydroxy group.
When the aromatic ring is substituted with two or more substituents, these substituents may be either the same or different, and adjacent substituents may be bonded to each other to form a saturated or unsaturated ring structure.

$R^1$ to $R^8$ are independently a hydrogen atom, a substituted or unsubstituted aryl group having 6 to 50 ring carbon atoms, a substituted or unsubstituted heteroaryl group having 5 to 50 ring atoms, a substituted or unsubstituted alkyl group having 1 to 50 carbon atoms, a substituted or unsubstituted cycloalkyl group having 3 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 ring atoms, a substituted or unsubstituted arythio group having 5 to 50 ring atoms, a substituted or unsubstituted alkoxycarbonyl group having 1 to 50 carbon atoms, a substituted or unsubstituted silyl group, a carboxyl group, a halogen atom, a cyano group, a nitro group or a hydroxy group.

In the above formula (25), it is preferred that $A^1$ and $A^2$ be different from each other.

As the host material for use in the second emitting layer, the compounds represented by the following formulas (i) to (ix) are preferred.

Asymmetrical anthrathene represented by the following formula (i)

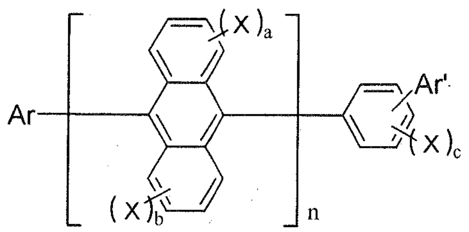

(i)

wherein Ar is a substituted or unsubstituted condensed aromatic group having 10 to 50 ring carbon atoms,

Ar' is a substituted or unsubstituted aromatic group having 6 to 50 ring carbon atoms,

X is a substituted or unsubstituted aromatic group having 6 to 50 ring carbon atoms, substituted or unsubstituted aromatic heterocyclic group having 5 to 50 ring atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 ring atoms, a substituted or unsubstituted arythio group having 5 to 50 ring atoms, a substituted or unsubstituted alkoxycarbonyl group having 1 to 50 carbon atoms, a carboxyl group, a halogen atom, a cyano group, a nitro group or a hydroxyl group.

a, b and c are each an integer of 0 to 4.

n is an integer of 1 to 3. When n is two or more, the groups in [] may be the same or different.

Asymmetrical monoanthrathene derivatives represented by the following formula (ii)

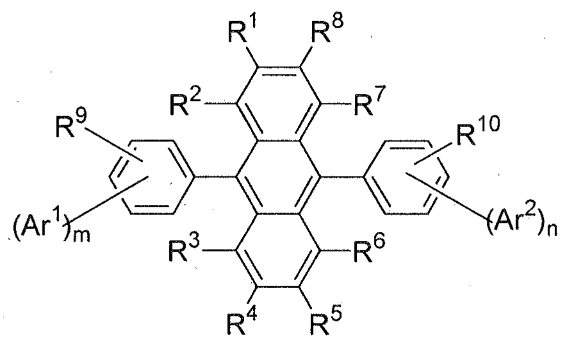

(ii)

wherein $Ar^1$ and $Ar^2$ are independently a substituted or unsubstituted aromatic ring group having 6 to 50 ring carbon atoms, and m and n are each an integer of 1 to 4, provided that in the case where m=n=1 and $Ar^1$ and $Ar^2$ are symmetrically bonded to the benzene rings, $Ar^1$ and $Ar^2$ are not the same, and in the case where m or n is an integer of 2 to 4, m is different from n,

$R^1$ to $R^{10}$ are independently a hydrogen atom, a substituted or unsubstituted aromatic ring group having 6 to 50 ring carbon atoms, a substituted or unsubstituted aromatic hetrocyclic group having 5 to 50 ring atoms, a substituted or unsubstituted alkyl group having 1 to 50 carbon atoms, a substituted or unsubstituted cycloalkyl group, a substituted or unsubstituted alkoxy group having 1 to 50 carbon atoms, a substituted or unsubstituted aralkyl group having 6 to 50

carbon atoms, a substituted or unsubstituted aryloxy group having 5 to 50 ring atoms, a substituted or unsubstituted arylthio group having 5 to 50 ring atoms, a substituted or unsubstituted alkoxycarbonyl group having 1 to 50 carbon atoms, a substituted or unsubstituted silyl group, a carboxyl group, a halogen atom, a cyano group, a nitro group or a hydroxyl group.

Asymmetrical pyrene derivatives represented by the following Formula (iii)

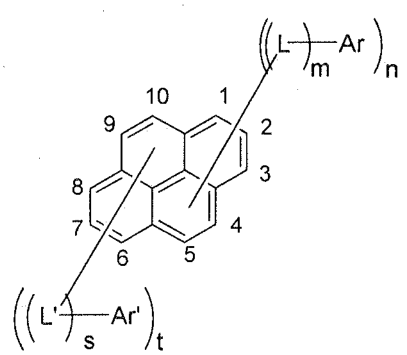

(iii)

wherein Ar and Ar' are each a substituted or unsubstituted aromatic group having 6 to 50 ring carbon atoms; L and L' are each a substituted or unsubstituted phenylene group, a substituted or unsubstituted naphthalenylene group, a substituted or unsubstituted fluolenylene group, or a substituted or unsubstituted dibenzosilolylene group;
m is an integer of 0 to 2, n is an integer of 1 to 4, s is an integer of 0 to 2, and t is an integer of 0 to 4;
L or Ar bonds at any one position of 1 to 5 of the pyrene, and L' or Ar' bonds at any one position of 6 to 10 of the pyrene; provided that when n+t is an even number, Ar, Ar', L and L' satisfy the following (1) and (2):

(1) Ar≠Ar' and/or L≠L' where ≠ means these substituents are groups having different structures from each other.
(2) when Ar=Ar' and L=L',

(2-1) m≠s and/or n≠t, or
(2-2) when m=s and n=t,

(2-2-1) L and L', or the pyrene each bond to Ar and Ar' at different positions, or
(2-2-2) when L and L', or the pyrene each bond to Ar and Ar' at the same positions, the pyrene is neither substituted by L and L', or Ar and Ar' at 1 and 6 positions, nor 2 and 7 positions.

Asymmetrical anthrathene represented by the following formula (iv)

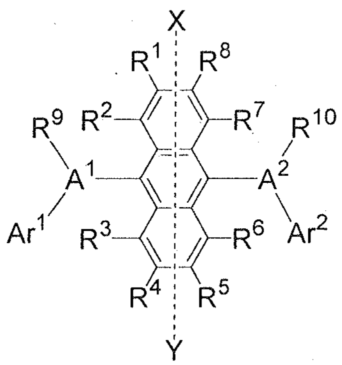

(iv)

wherein $A^1$ and $A^2$ are independently a substituted or unsubstituted condensed aromatic ring group having 10 to 20 ring carbon atoms,
$Ar^1$ and $Ar^2$ are independently a hydrogen atom or a substituted or unsubstituted aromatic ring group with 6 to 50 ring

carbon atoms,

$R^1$ to $R^{101}$ are independently a hydrogen atom or a substituted or unsubstituted aromatic ring group having 6 to 50 ring carbon atoms, a substituted or unsubstituted aromatic hetrocyclic group having 5 to 50 ring atoms, a substituted or unsubstituted alkyl group having 1 to 50 carbon atoms, a substituted or unsubstituted cycloalkyl group, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 ring atoms, a substituted or unsubstituted arylthio group having 5 to 50 ring atoms, a substituted or unsubstituted alkoxycarbonyl group having 1 to 50 carbon atoms, a substituted or unsubstituted silyl group, a carboxyl group, a halogen atom, a cyano group, a nitro group or a hydroxyl group, and

each of $Ar^1$, $Ar^2$, $R^9$ and $R^{10}$ may be plural, and adjacent groups thereof may form a saturated or unsaturated ring structure, provided that groups do not symmetrically bond to 9 and 10 positions of the central anthracene with respect to X-Y axis.

Anthrathene derivative represented by the following formula (v)

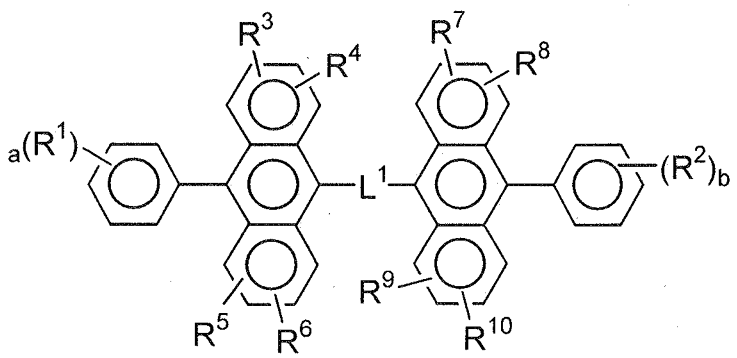

(v)

wherein $R^1$ to $R^{10}$ are independently a hydrogen atom, an alkyl group, a cycloalkyl group, an aryl group which may be substituted, an alkoxy group, an aryloxy group, an alkylamino group, an alkenyl group, an arylamino group or a heterocyclic group which may be substituted; a and b are each an integer of 1 to 5; when they are 2 or more, $R^1$s or $R^2$s may be the same or different, or $R^1$s or $R^2$s may be bonded together to form a ring; $R^3$ and $R^4$, $R^5$ and $R^6$, $R^7$ and $R^8$, or $R^9$ and $R^{10}$ may be bonded together to form a ring; and $L^1$ is a single bond, -O-, -S-, -N(R)- (R is an alkyl group or a substituted or unsubstituted aryl group), an alkylene group or an arylene group.

Anthrathene derivative represented by the following formula (vi)

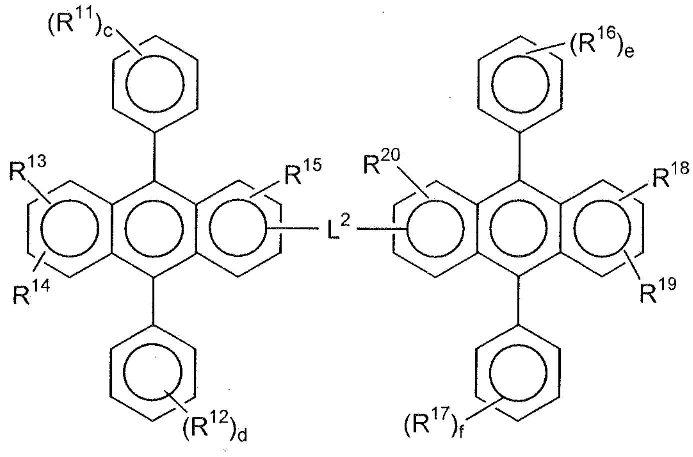

(vi)

wherein $R^{11}$ to $R^{20}$ are independently a hydrogen atom, an alkyl group, a cycloalkyl group, an aryl group, an alkoxy group, an aryloxy group, an alkylamino group, an arylamino group or a heterocyclic group which may be substituted; c, d, e and f are each an integer of 1 to 5; when they are 2 or more, $R^{11}$s, $R^{12}$s, $R^{16}$s or $R^{17}$s may be the same or different, $R^{11}$s, $R^{12}$s, $R^{16}$s or $R^{17}$s may be bonded together to form a ring, or $R^{13}$ and $R^{14}$, or $R^{18}$ and $R^{19}$ may be bonded together to form a ring; and $L^2$ is a single bond, -O-, -S-, -N(R)- (R is an alkyl group or a substituted or unsubstituted

aryl group), an alkylene group or an arylene group.

Spirofluorene derivatives represented by the following formula (vii)

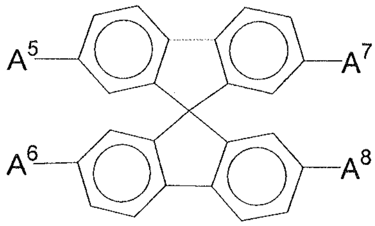

(vii)

wherein $A^5$ to $A^8$ are each independently a substituted or unsubstituted biphenyl group or a substituted or unsubstituted naphthyl group.

Condensed ring-containing compounds represented by the following formula (viii)

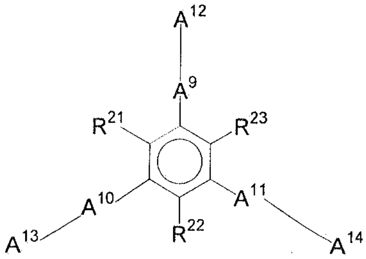

(viii)

wherein $A^9$ to $A^{11}$ are individually a substituted or unsubstituted arylene group having 6 to 50 ring carbon atoms, $A^{12}$ to $A^{14}$ are individually a hydrogen atom or a substituted or unsubstituted aryl group having 6 to 50 ring carbon atoms, and $R^{21}$ to $R^{23}$ are individually a hydrogen atom, alkyl group having 1 to 6 carbon atoms, cycloalkyl group having 3 to 6 carbon atoms, alkoxy group having 1 to 6 carbon atoms, aryloxy group having 5 to 18 carbon atoms, aralkyloxy group having 7 to 18 carbon atoms, arylamino group having 5 to 16 carbon atoms, nitro group, cyano group, ester group having 1 to 6 carbon atoms, or a halogen atom, provided that at least one of $A^9$ to $A^{14}$ is a group having a condensed aromatic ring with three or more rings.

Fluorene compounds represented by the following formula (ix)

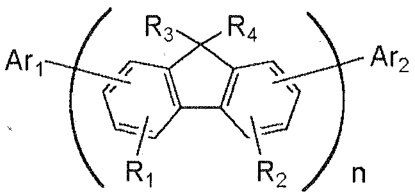

(ix)

wherein $R_1$ and $R_2$ are a hydrogen atom, a substituted or unsubstituted alkyl group, substituted or unsubstituted aralkyl group, substituted or unsubstituted aryl group, substituted or unsubstituted heterocyclic group, substituted amino group, cyano group, or a halogen atom. $R_1$s or $R_2$s bonded to different fluorene groups may be the same or different, and $R_1$ and $R_2$ bonded to a single fluorene group may be the same or different. $R_3$ and $R_4$ are a hydrogen atom, a substituted or unsubstituted alkyl group, substituted or unsubstituted aralkyl group, substituted or unsubstituted aryl group, or substituted or unsubstituted heterocyclic group, provided that $R_3$s or $R_4$s bonded to different fluorene groups may be the same or different, and $R_3$ and $R_4$ bonded to a single fluorene group may be the same or different. $Ar_1$ and $Ar_2$ are a substituted or unsubstituted condensed polycyclic aromatic group with a total number of benzene rings of three or more or a condensed polycyclic heterocyclic group which is bonded to the fluorene group through substituted or unsubstituted carbon and has a total number of benzene rings and heterocyclic rings of three or more, provided that $Ar_1$

and $Ar_2$ may be the same or different. n is an integer of 1 to 10.

Among the above compounds, the host material is preferably the anthracene derivative, more preferably the monoanthracene derivative, and particularly the asymmetrical anthracene.

As examples of the dopant which may be used for the second emitting layer, an arylamine compound and/or styryl amine compound, anthracene, naphthalene, phenanthrene, pyrene, tetracene, coronene, chrysene, fluoresceine, perylene, phthaloperylene, naphthaloperylene, perynone, phthaloperynone, naphthaloperynone, diphenylbutadiene, tetraphenylbutadiene, coumarin, oxadizole, aldazine, bisbenzoxazoline, bisstyryl, pyrazine, cyclopentadiene, quinoline metal complex, aminoquinoline metal complex, benzoquinoline metal complex, imine, diphenylethylene, vinylanthracene, diaminocarbazole, pyrane, thiopyran, polymethine, merocyanine, imidazole chelated oxynoid compound, quinacridon, rubrene, fluorescent dye, and the like can be given. Note that the material for the second emitting layer is not limited thereto.

In the organic EL device of the invention, the second emitting layer preferably contains an arylamine compound and/or a styrylamine compound.

As examples of the arylamine compound, a compound of the following formula (26) can be given. As examples of the styrylamine compound, a compound of the following formula (27) can be given.

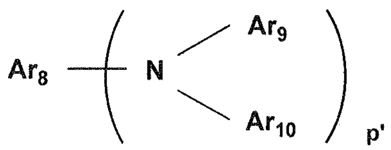
(26)

wherein $Ar_8$ is a group selected from phenyl, biphenyl, terphenyl, stilbene, and distyrylaryl, and $Ar_9$ and $Ar_{10}$ are independently a hydrogen atom or an aromatic group having 6 to 20 carbon atoms, provided that $Ar_9$ and $Ar_{10}$ may be substituted. p' is an integer of 1 to 4.

Preferably, $Ar_9$ and/or $Ar_{10}$ is substituted with a styryl group.

As the aromatic group having 6 to 20 carbon atoms, a phenyl group, naphthyl group, anthracenyl group, phenanthryl group, terphenyl group, and the like are preferable.

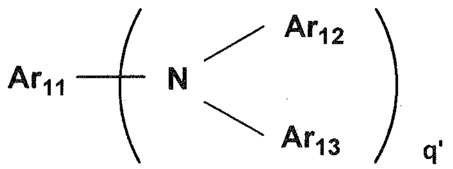
(27)

wherein $Ar_{11}$ to $Ar_{13}$ are aryl groups having 5 to 40 ring carbon atoms which may be substituted. q' is an integer of 1 to 4.

As the aryl groups having 5 to 40 ring atoms, phenyl, naphthyl, anthracenyl, phenanthryl, pyrenyl, coronyl, biphenyl, terphenyl, pyrrolyl, furanyl, thiophenyl, benzothiophenyl, oxadiazolyl, diphenylanthracenyl, indolyl, carbazolyl, pyridyl, benzoquinolyl, fluoranthenyl, acenaphthofluoranthenyl, stilbene, and the like are preferable. The aromatic group having 5 to 40 ring atoms may be substituted with a substituent. Given as preferred substituents are alkyl groups having 1 to 6 carbon atoms (e.g. ethyl group, methyl group, i-propyl group, n-propyl group, s-butyl group, t-butyl group, pentyl group, hexyl group, cyclopentyl group, and cyclohexyl group), alkoxy groups having 1 to 6 carbon atoms (e.g. ethoxy group, methoxy group, i-propoxy group, n-propoxy group, s-butoxy group, t-butoxy group, pentoxy group, hexyloxy group, cyclopentoxy group, and cyclohexyloxy group), aryl groups having 5 to 40 ring atoms, amino groups substituted with an aryl group having 5 to 40 ring atoms, ester groups containing an aryl group having 5 to 40 ring atoms, ester groups containing an alkyl group having 1 to 6 carbon atoms, cyano group, nitro group, and halogen atoms (e.g. chlorine, bromine, and iodine).

The thickness of the second emitting layer is preferably 1 to 100 nm, more preferably 5 to 50 nm. When it is less than 1 nm, the formation of an emitting layer and the adjustment of chromaticity may become difficult. When it exceeds 100 nm, the driving voltage may increase.

4. Third emitting layer

For color of emitted light, the third emitting layer is preferably green emitting layer. The green emission preferably has a maximum wavelength of 500 to 550 nm.

The third emitting layer preferably comprises a host material and a green dopant. The same specific materials as those for the second emitting layer can be used. The host material is preferably the same as that of the second emitting layer.

The green dopant is preferably the arylamine compound and/or the styrylamine compound given as the blue dopant. The maximum wavelength of the green light is preferably 500 to 550 nm.

The green dopant is preferably an aromatic amine compound of the following formula (28).

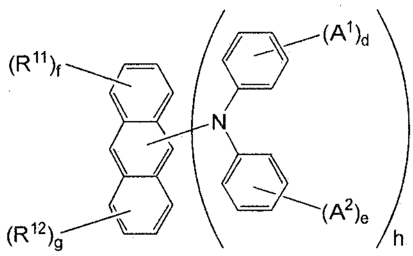

(28)

In the formula (28), $A^1$ to $A^2$ are independently a hydrogen atom, a substituted or unsubstituted alkyl group having 1 to 10 carbon atoms (preferably 1 to 6 carbon atoms), a substituted or unsubstituted aryl group having 5 to 50 ring carbon atoms (preferably 5 to 10 ring carbon atoms), a substituted or unsubstituted cycloalkyl group having 3 to 20 ring carbon atoms (preferably 5 to 10 ring carbon atoms), a substituted or unsubstituted alkoxy group having 1 to 10 carbon atoms (preferably 1 to 6 carbon atoms), a substituted or unsubstituted aryloxy group having 5 to 50 ring carbon atoms (preferably 5 to 10 ring carbon atoms), a substituted or unsubstituted arylamino group having 5 to 50 ring carbon atoms (preferably 5 to 20 ring carbon atoms), a substituted or unsubstituted alkylamino group having 1 to 10 carbon atoms (preferably 1 to 6 carbon atoms), or a halogen atom.

The substituted or unsubstituted alkyl group of $A^1$ to $A^2$ includes methyl, ethyl, propyl, isopropyl, butyl, sec-butyl, tert-butyl, pentyl, hexyl, heptyl, octyl, stearyl, 2-phenylisopropyl, trichloromethyl, trifluoromethyl, benzyl, α-phenoxybenzyl, α,α-dimethylbenzyl, α,α-methylphenylbenzyl, α,α-ditrifluoromethylbenzyl, triphenylmethyl, and α-benzyloxybenzyl groups.

The substituted or unsubstituted aryl group of $A^1$ to $A^2$ includes phenyl, 2-methylphenyl, 3-methylphenyl, 4-methylphenyl, 4-ethylphenyl, biphenyl, 4-methylbiphenyl, 4-ethylbiphenyl, 4-cyclohexylbiphenyl, terphenyl, 3,5-dichlorophenyl, naphtyl, 5-methylnaphtyl, anthryl, and pyrenyl groups.

The substituted or unsubstituted cycloalkyl group of $A^1$ to $A^2$ includes cyclopropyl, cyclobutyl, cyclopentyl, cyclohexyl, norbornyl, and adamantyl groups.

The substituted or unsubstituted alkoxy group of $A^1$ to $A^2$ includes methoxy, ethoxy, propoxy, isopropoxy, butoxy, isobutoxy, sec-butoxy, tert-butoxy, various pentyloxy, and various hexyloxy groups.

The substituted or unsubstituted aryloxy group of $A^1$ to $A^2$ includes phenoxy, tolyloxy, and naphthyloxy groups.

The substituted or unsubstituted arylamino group of $A^1$ to $A^2$ includes diphenylamino, ditolylamino, dinaphthylamino, and naphthylphenylamino groups.

The substituted or unsubstituted alkylamino group of $A^1$ to $A^2$ includes dimethylamino, diethylamino, and dihexylamino groups.

The halogen atom of $A^1$ to $A^2$ includes fluoride, chlorine, and bromine atoms.

In formula (28), $A^1$ and $A^2$ cannot be hydrogen atoms at the same time.

In formula (28), d and e are each an integer of 1 to 5, preferably 1 to 3. When d and e are each 2 or more, $A^1$s and $A^2$s may be the same or different. They may be joined together to form a saturated or unsaturated ring. h is an integer of 1 to 9, preferably 1 to 3.

$R^{11}$ is a substituted or unsubstituted secondary or tertiary alkyl group having 3 to 10 carbon atoms or a substituted or unsubstituted secondary or tertiary cycloalkyl group having 3 to 10 carbon atoms.

The substituted or unsubstituted secondary or tertiary alkyl group having 3 to 10 carbon atoms of $R^{11}$ includes isopropyl, tert-butyl, sec-butyl, tert-pentyl, 1-methylbutyl, 1-methylpentyl, 1,1'-dimethylpentyl, 1,1'-diethylpropyl, 1-benzyl-2-phenylethyl, 1-methoxyethyl, and 1-phenyl-l-methylethyl groups.

The substituted or unsubstituted secondary or tertiary cycloalkyl group having 3 to 10 carbon atoms of $R^{11}$ includes cyclopentyl, cyclohexyl, norbornyl, and adamantyl groups.

In formula (28), f is an integer of 1 to 9, preferably 1 to 3. When f is 2 or more, $R^{11}$s may be the same or different.

$R^{12}$ is a hydrogen atom, a substituted or unsubstituted alkyl group having 1 to 10 carbon atoms (preferably 1 to 6 carbon atoms), a substituted or unsubstituted aryl group having 5 to 50 ring carbon atoms (preferably 5 to 10 ring carbon atoms), a substituted or unsubstituted cycloalkyl group having 3 to 20 ring carbon atoms (preferably 5 to 10 ring carbon atoms), a substituted or unsubstituted alkoxy group having 1 to 10 carbon atoms (preferably 1 to 6 carbon atoms),

a substituted or unsubstituted aryloxy group having 5 to 50 ring carbon atoms (preferably 5 to 10 ring carbon atoms), a substituted or unsubstituted arylamino group having 5 to 50 ring carbon atoms (preferably 5 to 20 ring carbon atoms), a substituted or unsubstituted alkylamino group having 1 to 10 carbon atoms (preferably 1 to 6 carbon atoms), or a halogen atom.

Examples of the substituted or unsubstituted alkyl, aryl, cycloalkyl, alkoxy, aryloxy, arylamino, and alkylamino groups and halogen atom of $R^{12}$ include the same groups and atoms as those of $A^1$ to $A^2$ mentioned above.

In formula (28), g is an integer of 0 to 8 and preferably 0 to 2.

When g is 2 or more, $R^{12}$s may be the same or different.

In formula (28), f+g+h is an integer of 2 to 10 and preferably 2 to 6.

More preferred are compounds represented by formulas (28-1) to (28-7) as the aromatic amine compound.

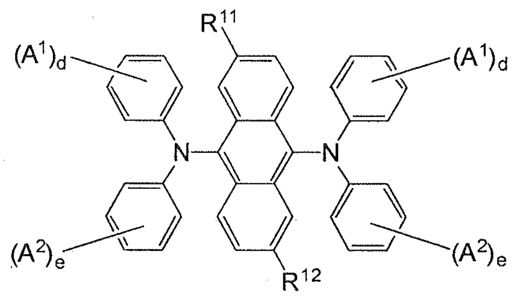

(28-1)

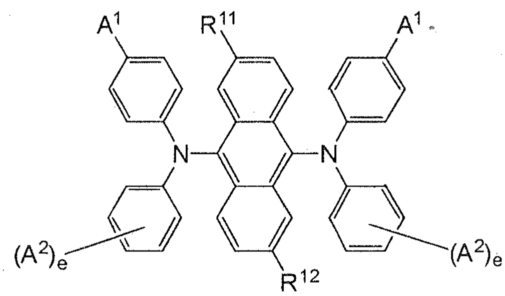

(28-2)

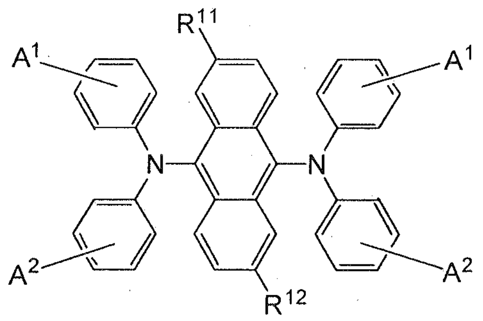

(28-3)

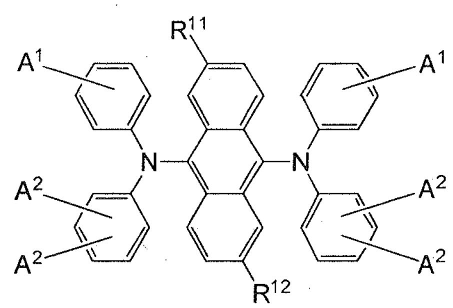

(28-4)

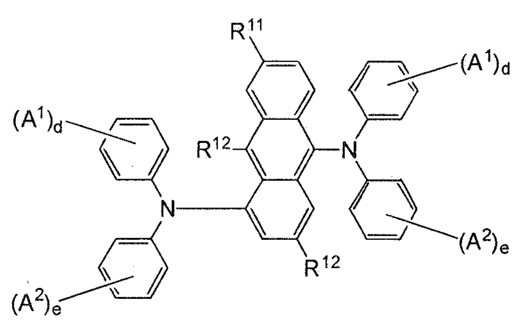

(28-5)

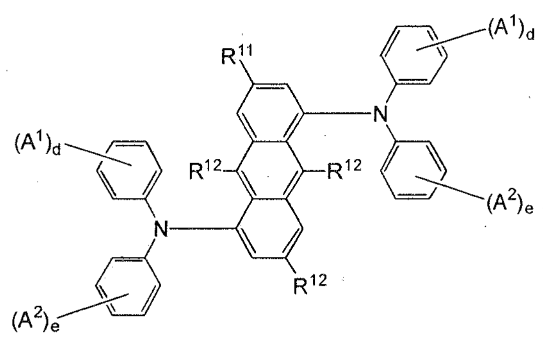

(28-6)

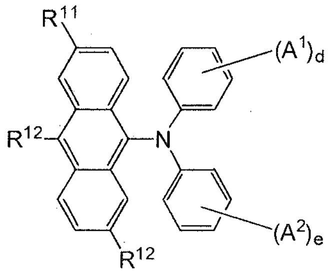

(28-7)

In formulas (28-1) to (28-7), $A^1$, $A^2$, d, e, $R^{11}$ and $R^{12}$ are the same as those in formula (28).

The thickness of the third emitting layer is preferably 1 to 100 nm, more preferably 5 to 50 nm. When it is less than 1 nm, the formation of an emitting layer and the adjustment of chromaticity may become difficult. When it exceeds 100 nm, the driving voltage may increase.

5. Other organic layers

(1) First organic layer

A hole-injecting layer, a hole-transporting layer, an organic semiconductor layer or the like can be arranged between the anode and the first emitting layer as a first organic layer. The hole-injecting layer or the hole-transporting layer is a layer for helping the injection of holes into the emitting layer so as to transport holes to an emitting region. The hole mobility thereof is large and the ionization energy thereof is usually as small as 5.5 eV or less. A hole-injecting layer is formed to control energy level, for example, to reduce precipitous energy level changes. Such a hole-injecting or hole-transporting layer is preferably made of a material which can transport holes to the emitting layer at a low electric field intensity. The hole mobility thereof is preferably at least $10^{-6}$ $cm^2/V \cdot$second when an electric field of, e.g., $10^4$ to $10^6$ V/cm is applied. Any materials which have the above preferable properties can be used as the material for forming the hole-injecting layer or the hole-transporting layer without particular limitation. The material for forming the hole-injecting layer or the hole-transporting layer can be arbitrarily selected from materials which have been widely used as a material transporting carriers of holes in photoconductive materials and known materials used in a hole-injecting layer of organic EL devices.

Specific examples of materials for a hole-injecting layer and a hole-transporting layer, include triazole derivatives (see USP No. 3,112,197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, and 54-119925, and others), arylamine derivatives (see USP Nos. 3,567,450, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3,526,501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 57-11350, 57-148749 and 2-311591, and others), stilbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), and aniline copolymers (JP-A-2-282263).

The above-mentioned substances can be used as the material of the hole-injecting layer or the hole-transporting layer. The following can also be used: porphyrin compounds (disclosed in JP-A-63-295695 and others), aromatic tertiary amine compounds and styrylamine compounds (see USP No. 4,127,412, JP-A-53-27033, 54-58445, 55-79450, 55-144250, 56-119132, 61-295558, 61-98353 and 63-295695, and others), and aromatic tertiary amine compounds. The following can also be given as examples: 4,4'-bis(N-(1-naphthyl)-N-phenylamino)biphenyl, which has in the molecule thereof two condensed aromatic rings, disclosed in USP No. 5,061,569, and 4,4',4"-tris(N-(3-methylphenyl)-N-phenylamino)triphenylamine, wherein three triphenylamine units are linked to each other in a star-burst form, disclosed in JP-A-4-308688. Inorganic compounds such as aromatic dimethylidene type compounds, mentioned above as the material for an emitting layer, and p-type Si and p-type SiC can also be used as the material of the hole-injecting layer or the hole-transporting layer.

This hole-injecting layer or the hole-transporting layer may be a single layer made of one or more of the above-mentioned materials, or may be stacked hole-injecting layers or hole-transporting layers made of different compounds. The thickness of the hole-injecting layer or the hole-transporting layer is not particularly limited, and is preferably 20 to 200 nm.
The organic semiconductor layer is a layer for helping the injection of holes or electrons into the emitting layer, and is preferably a layer having an electric conductivity of $10^{-10}$ S/cm or more. As the material of such an organic semiconductor layer, electroconductive oligomers such as thiophene-containing oligomers or arylamine-containing oligomers disclosed in JP-A-8-193191, and electroconductive dendrimers such as arylamine-containing dendrimers may be used. The thickness of the organic semiconductor layer is not particularly limited, and is preferably 10 to 1,000 nm.

(2) Second organic layer

An electron injecting layer, an electron transporting layer, or the like may be provided between the cathode and the second emitting layer as the second organic layer. The electron injecting layer and electron transporting layer is a layer which assists injection of electrons into the emitting layer, and exhibits a high electron mobility. The thickness of the electron transporting layer is arbitrarily selected in the range of several nanometers to several micrometers. When the electron transporting layer has a large thickness, it is preferable that the electron mobility be at least $10^{-5}$ $cm^2/Vs$ or more at an applied electric field of $10^4$ to $10^6$ V/cm in order to prevent an increase in voltage.
As the material used for the electron injecting layer and electron transporting layer, 8-hydroxyquinoline, a metal complex of an 8-hydroxyquinoline derivative, and a compound having a nitrogen-containing heterocyclic ring are suitable.
As specific examples of 8-hydroxyquinoline and a metal complex of an 8-hydroxyquinoline derivative, metal chelate oxinoid compounds including a chelate of oxine (8-quinolinol or 8-hydroxyquinoline) can be given. For example, Alq having Al as the center metal may be used for the electron injecting layer and electron transporting layer.
An electron transporting compound of the following formula can be given as the oxadiazole derivative.
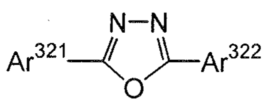

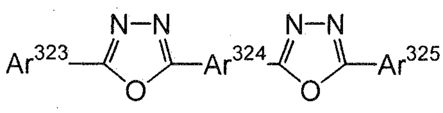

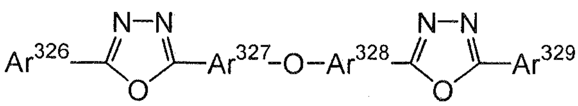

wherein $Ar^{321}$, $Ar^{322}$, $Ar^{123}$, $Ar^{325}$, $Ar^{326}$, and $Ar^{329}$ are individually substituted or unsubstituted aryl groups and may be the same or different. $Ar^{324}$, $Ar^{327}$, and $Ar^{328}$ are individually substituted or unsubstituted arylene groups and may be the same or different.
As examples of the aryl group, a phenyl group, a biphenyl group, an anthranyl group, a perylenyl group, and a pyrenyl group can be given. As examples of the arylene group, a phenylene group, a naphthylene group, a biphenylene group, an anthranylene group, a perylenylene group, a pyrenylene group, and the like can be given. As the substituent, an alkyl group having 1 to 10 carbon atoms, an alkoxy group having 1 to 10 carbon atoms, a cyano group, and the like can be given. The electron transporting compound is preferably one from which a thin film can be formed.
The following compounds can be given as specific examples of the electron transporting compound.
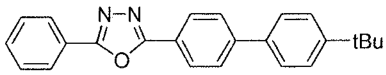

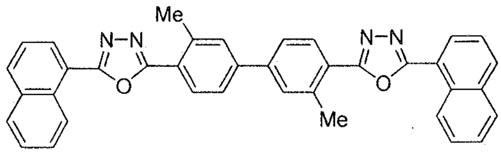

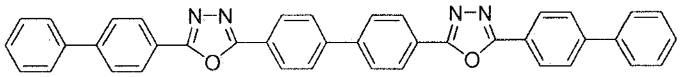

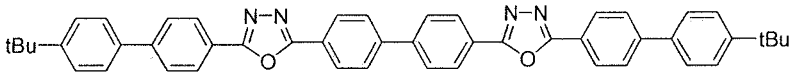

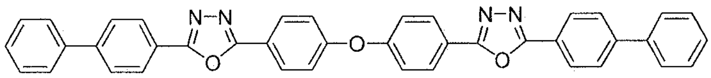

wherein Me is a methyl group, and Bu is a butyl group.

Nitrogen-containing heterocyclic ring derivatives of the following formulas

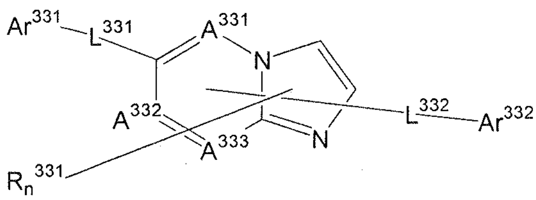

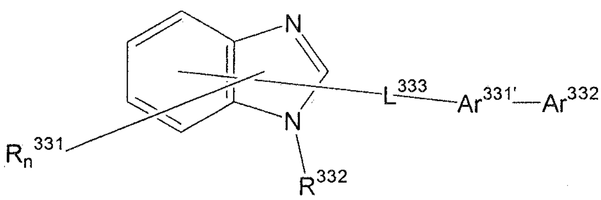

wherein $A^{331}$ to $A^{333}$ are a nitrogen atom or a carbon atom; $R^{331}$ and $R^{332}$ are a substituted or unsubstituted aryl group having 6 to 60 carbon atoms, a substituted or unsubstituted heteroaryl group having 3 to 60 carbon atoms, an alkyl group having 1 to 20 carbon atoms, a haloalkyl group having 1 to 20 carbon atoms, or an alkoxy group having 1 to 20 carbon atoms, and n is an integer of 0 to 5, provided that, when n is an integer of 2 or more, $R^{331}$s may be the same or different; adjacent $R^{331}$s may be bonded to form a substituted or unsubstituted carbocyclic aliphatic ring or a substituted or unsubstituted carbocyclic aromatic ring; $Ar^{331}$ is a substituted or unsubstituted aryl group having 6 to 60 carbon atoms or a substituted or unsubstituted heteroaryl group having 3 to 60 carbon atoms; $Ar^{331'}$ is a substituted or unsubstituted arylene group having 6 to 60 carbon atoms or a substituted or unsubstituted heteroarylene group having 3 to 60 carbon atoms; $Ar^{332}$ is a hydrogen atom, an alkyl group having 1 to 20 carbon atoms, a haloalkyl group having 1 to 20 carbon

atoms, an alkoxy group having 1 to 20 carbon atoms, a substituted or unsubstituted aryl group having 6 to 60 carbon atoms, or a substituted or unsubstituted heteroaryl group having 3 to 60 carbon atoms; provided that one of $Ar^{331}$ and $Ar^{332}$ is a substituted or unsubstituted condensed ring group having 10 to 60 carbon atoms or a substituted or unsubstituted heterocondensed ring group having 3 to 60 carbon atoms; and $L^{331}$, $L^{332}$, and $L^{333}$ are individually a single bond, a substituted or unsubstituted condensed ring having 6 to 60 carbon atoms, a substituted or unsubstituted heterocondensed ring having 3 to 60 carbon atoms, or a substituted or unsubstituted fluorenylene group.

Nitrogen-containing heterocyclic ring derivatives of the following formula disclosed in Japanese Patent Application No. 2003-004193

$$HAr\text{-}L^{341}\text{-}Ar^{341}\text{-}Ar^{342}$$

wherein HAr is a substituted or unsubstituted nitrogen-containing heterocyclic ring having 3 to 40 carbon atoms, $L^{341}$ is a single bond, a substituted or unsubstituted arylene group having 6 to 60 carbon atoms, a substituted or unsubstituted heteroarylene group having 3 to 60 carbon atoms, or a substituted or unsubstituted fluorenylene group, $Ar^{341}$ is a divalent substituted or unsubstituted aromatic hydrocarbon group having 6 to 60 carbon atoms, and $Ar^{342}$ is a substituted or unsubstituted aryl group having 6 to 60 carbon atoms or a substituted or unsubstituted heteroaryl group having 3 to 60 carbon atoms.

Silacyclopentadiene derivatives of the following formula disclosed in JP-A-09-087616

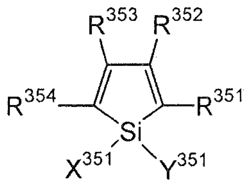

wherein $X^{351}$ and $Y^{351}$ are individually a saturated or unsaturated hydrocarbon group having 1 to 6 carbon atoms, an alkoxy group, an alkenyloxy group, an alkynyloxy group, a hydroxyl group, a substituted or unsubstituted aryl group, or a substituted or unsubstituted hetero ring, or $X^{351}$ and $Y^{351}$ are bonded to form a saturated or unsaturated ring, and $R^{351}$ to $R^{354}$ are individually hydrogen, halogen, a substituted or unsubstituted aryl group having 1 to 6 carbon atoms, an alkoxy group, an aryloxy group, a perfluoroalkyl group, a perfluoroalkoxy group, an amino group, an alkylcarbonyl group, an arylcarbonyl group, an alkoxycarbonyl group, an aryloxycarbonyl group, an azo group, an alkylcarbonyloxy group, an arylcarbonyloxy group, an alkoxycarbonyloxy group, an aryloxycarbonyloxy group, a sulfinyl group, a sulfonyl group, a sulfanyl group, a silyl group, a carbamoyl group, an aryl group, a heterocyclic group, an alkenyl group, an alkynyl group, a nitro group, a formyl group, a nitroso group, a formyloxy group, an isocyano group, a cyanate group, an isocyanate group, a thiocyanate group, an isothiocyanate group, or a cyano group, or adjacent groups of $R^{351}$ to $R^{354}$ from a substituted or unsubstituted condensed ring.

Silacyclopentadiene derivatives of the following formula disclosed in JP-A-09-194487

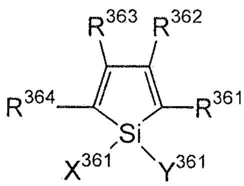

wherein $X^{361}$ and $Y^{361}$ are individually a saturated or unsaturated hydrocarbon group having 1 to 6 carbon atoms, alkoxy group, alkenyloxy group, alkynyloxy group, substituted or unsubstituted aryl group, or substituted or unsubstituted hetero ring, or $X^{361}$ and $Y^{361}$ are bonded to form a saturated or unsaturated ring, and $R^{361}$ to $R^{364}$ are individually hydrogen, halogen, substituted or unsubstituted alkyl group having 1 to 6 carbon atoms, alkoxy group, aryloxy group, perfluoroalkyl group, perfluoro alkoxy group, amino group, alkylcarbonyl group, arylcarbonyl group, alkoxycarbonyl group, aryloxycarbonyl group, azo group, alkylcarbonyloxy group, arylcarbonyloxy group, alkoxycarbonyloxy group, aryloxycarbonyloxy group, sulfinyl group, sulfonyl group, sulfanyl group, silyl group, carbamoyl group, aryl group, heterocyclic group, alkenyl group, alkynyl group, nitro group, formyl group, nitroso group, formyloxy group, isocyano group, cyanate group, isocyanate

group, thiocyanate group, isothiocyanate group, or cyano group, or adjacent groups of $R^{361}$ to $R^{364}$ form a substituted or unsubstituted condensed ring, (provided that, when $R^{361}$ and $R^{364}$ are phenyl groups, $X^{361}$ and $Y^{361}$ are neither an alkyl group nor a phenyl group, when $R^{361}$ and $R^{364}$ are thienyl groups, a case is excluded in which $X^{361}$ and $Y^{361}$ are monovalent hydrocarbon groups and $R^{362}$ and $R^{363}$ are an alkyl group, an aryl group, an alkenyl group, or $R^{362}$ and $R^{363}$ are aliphatic groups which form a ring by bonding to each other, when $R^{361}$ and $R^{364}$ are silyl groups, $R^{362}$, $P^{363}$, $X^{361}$, and $Y^{361}$ are neither individually a monovalent hydrocarbon group having 1 to 6 carbon atoms nor a hydrogen atom, and when a benzene ring is condensed at the positions of $R^{361}$ and $R^{362}$, $X^{361}$ and $Y^{361}$ are neither an alkyl group nor a phenyl group).

Borane derivatives of the following formula disclosed in JP-T-2000-040586

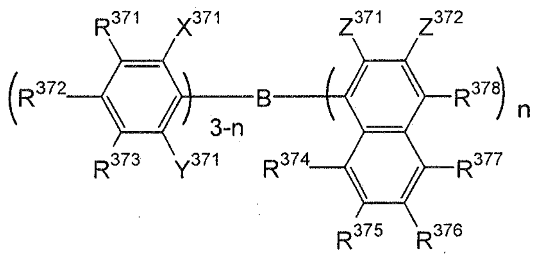

wherein $R^{371}$ to $R^{378}$ and $Z^{372}$ are individually a hydrogen atom, a saturated or unsaturated hydrocarbon group, an aromatic group, a heterocyclic group, a substituted amino group, a substituted boryl group, an alkoxy group, or an aryloxy group, $X^{371}$, $Y^{371}$, and $Z^{371}$ are individually a saturated or unsaturated hydrocarbon group, an aromatic group, a heterocyclic group, a substituted amino group, an alkoxy group, or an aryloxy group, the substituents for $Z^{371}$ and $Z^{372}$ may be bonded to form a condensed ring, n is an integer of 1 to 3, provided that the $Z^{371}$s may differ when n is 2 or more, and a case in which n is 1, $X^{371}$, $Y^{371}$, and $R^{372}$ are methyl groups, and $R^{378}$ is a hydrogen atom or a substituted boryl group, and a case in which n is 3 and $Z^{371}$ is a methyl group are excluded.

Compounds of the following formula disclosed in JP-A-10-088121

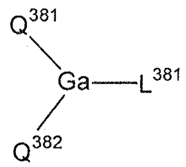

wherein $Q^{381}$ and $Q^{382}$ are individually ligands of the following formula, $L^{381}$ is a halogen atom, a substituted or unsubstituted alkyl group, a substituted or unsubstituted cycloalkyl group, a substituted or unsubstituted aryl group, a substituted or unsubstituted heterocyclic ring group, - $OR^{391}$ ($R^{391}$ is a hydrogen atom, a substituted or unsubstituted alkyl group, a substituted or unsubstituted cycloalkyl group, a substituted or unsubstituted aryl group, or a substituted or unsubstituted heterocyclic group), or - O-Ga-$Q^{391}$ ($Q^{392}$) ($Q^{391}$ and $Q^{392}$ have the same meanings as $Q^{381}$ and $Q^{382}$).

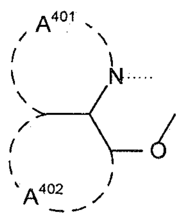

wherein the rings $A^{401}$ and $A^{402}$ are bonded and are a substituted or unsubstituted aryl ring or a heterocyclic ring structure.

Specific examples of the substituents for the rings $A^{401}$ and $A^{402}$ forming the ligand of the above formula include halogen atoms such as chlorine, bromine, iodine, and fluorine, substituted or unsubstituted alkyl groups such as a methyl group, ethyl group, propyl group, butyl group, sec-butyl group, tert-butyl group, pentyl group, hexyl group, heptyl group,

octyl group, stearyl group, and trichloromethyl group, substituted or unsubstituted aryl groups such as a phenyl group, naphthyl group, 3-methylphenyl group, 3-methoxyphenyl group, 3-fluorophenyl group, 3-trichloromethylphenyl group, 3-trifluoromethylphenyl group, and 3-nitrophenyl group, substituted or unsubstituted alkoxy groups such as a methoxy group, n-butoxy group, tert-butoxy group, trichloromethoxy group, trifluoroethoxy group, pentafluoropropoxy group, 2,2,3,3-tetrafluoropropoxy group, 1,1,1,3,3,3-hexafluoro-2-propoxy group, and 6-(perfluoroethyl)hexyloxy group, substituted or unsubstituted aryloxy groups such as a phenoxy group, p-nitrophenoxy group, p-tert-butylphenoxy group, 3-fluorophenoxy group, pentafluorophenyl group, and 3-trifluoromethylphenoxy group, substituted or unsubstituted alkylthio groups such as a methylthio group, ethylthio group, tert-butylthio group, hexylthio group, octylthio group, and trifluoromethylthio group, substituted or unsubstituted arylthio groups such as a phenylthio group, p-nitrophenylthio group, p-tert-butylphenylthio group, 3-fluorophenylthio group, pentafluorophenylthio group, and 3-trifluoromethylphenylthio group, a cyano group, a nitro group, an amino group, mono- or di-substituted amino groups such as a methylamino group, diethylamino group, ethylamino group, diethylamino group, dipropylamino group, dibutylamino group, and diphenylamino group, acylamino groups such as a bis(acetoxymethyl)amino group, bis(acetoxyethyl)amino group, bis(acetoxypropyl) amino group, and bis(acetoxybutyl)amino group, a hydroxyl group, a siloxy group, an acyl group, substituted or unsubstituted carbamoyl groups such as a carbamoyl group, methylcarbamoyl group, dimethylcarbamoyl group, ethylcarbamoyl group, diethylcarbamoyl group, propylcarbamoyl group, butylcarbamoyl group, and phenylcarbamoyl group, a carboxylic acid group, a sulfonic acid group, an imide group, cycloalkyl groups such as a cyclopentane group and a cyclohexyl group, aryl groups such as a phenyl group, naphthyl group, biphenyl group, anthranyl group, phenanthryl group, fluorenyl group, and pyrenyl group, heterocyclic groups such as a pyridinyl group, pyrazinyl group, pyrimidinyl group, pyridazinyl group, triazinyl group, indolinyl group, quinolinyl group, acridinyl group, pyrrolidinyl group, dioxanyl group, piperidinyl group, morpholidinyl group, piperazinyl group, carbazolyl group, furanyl group, thiophenyl group, oxazolyl group, oxadiazolyl group, benzooxazolyl group, thiazolyl group, thiadiazolyl group, benzothiazolyl group, triazolyl group, imidazolyl group, and benzimidazolyl group, and the like. The above substituents may be bonded to form a six-membered aryl ring or heterocyclic ring.

The thickness of the electron injecting layer or the electron transporting layer is preferably 1 to 100 nm, although the thickness is not particularly limited.

(3) Oxidizing agent

It is preferable that the first emitting layer or the first organic layer which is the organic layer closest to the anode include an oxidizing agent. A preferred oxidizing agent is an electron attracting agent or an electron acceptor. The electron attracting agent or electron acceptor is an organic compound which is easily reduced.
The ease to be reduced of the compound may be measured using the reduction potential. In the invention, a compound having a reduction potential of -0.8 V or more using a saturated calomel electrode (SCE) as the reference electrode is preferable, and a compound having a reduction potential greater than the reduction potential (about 0 V) of tetracyanoquinodimethane (TCNQ) is particularly preferable.

An organic compound having an electron-attracting substituent is preferable as the organic compound which is easily reduced. As specific examples of the organic compound having an electron-attracting substituent, quinoid derivatives, pyrazine derivatives, arylborane derivatives, imide derivatives, and the like can be given. The quinoid derivatives include quinodimethane derivatives, thiopyran dioxide derivatives, thioxanthene dioxide derivatives, quinone derivatives, and the like.

As preferred examples of the quinoid derivatives, compounds of the following formulas (1a) to (1h) can be given. Note that the compounds of the formulas (1a) and (1b) are more preferable.

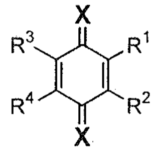
(1a)

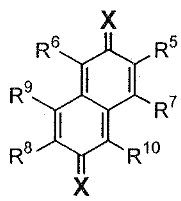
(1b)

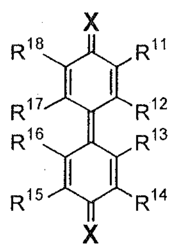
(1c)

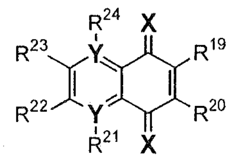
(1d)

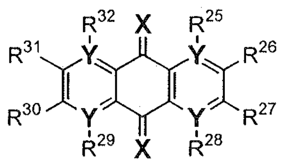
(1e)

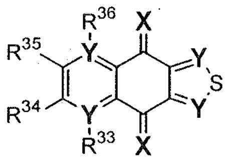
(1f)

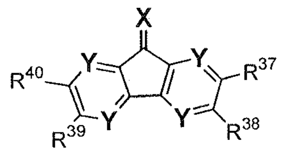
(1g)

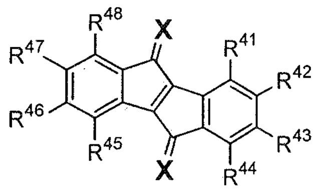
(1h)

In the formulas (1a) to (1h), $R^1$ to $R^{48}$ are individually hydrogen, halogen, a fluoroalkyl group, a cyano group, an alkoxy group, an alkyl group, or an aryl group. $R^1$ to $R^{48}$ are preferably hydrogen or a cyano group.

As the halogen for $R^1$ to $R^{48}$, fluorine and chlorine are preferable.

As the fluoroalkyl group for $R^1$ to $R^{48}$, a trifluoromethyl group and a pentafluoroethyl group are preferable.

As the alkoxy group for $R^1$ to $R^{48}$, a methoxy group, an ethoxy group, an iso-propoxy group, and a tert-butoxy group are preferable.

As the alkyl group for $R^1$ to $R^{48}$, a methyl group, an ethyl group, a propyl group, an iso-propyl group, a tert-butyl group, and a cyclohexyl group are preferable.

As the aryl group for $R^1$ to $R^{48}$, a phenyl group and a naphthyl group are preferable.

In the formulas (1a) to (1h), X is an electron-attracting group having one of the structures of the following formulas (j) to (p). Note that the structures of the formulas (j), (k), and (1) are preferable.

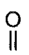
(j)

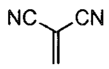
(k)

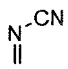
(l)

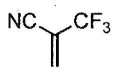
(m)

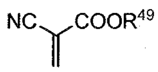
(n)

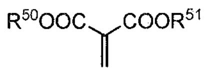
(o)

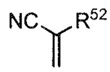
(p)

wherein $R^{49}$ to $R^{52}$ are individually hydrogen, a fluoroalkyl group, an alkyl group, an aryl group, or a heterocyclic ring, provided that $R^{50}$ and $R^{51}$ may form a ring.

The fluoroalkyl group, alkyl group, and aryl group for $R^{49}$ to $R^{52}$ are the same as those for $R^1$ to $R^{48}$.

As the heterocyclic ring for $R^{49}$ to $R^{52}$, substituents of the following formulas are preferable.

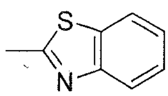

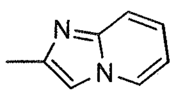

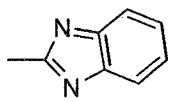

When $R^{50}$ and $R^{51}$ form a ring, X is preferably a substituent of the following formula.

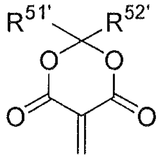

wherein $R^{51'}$ and $R^{52'}$ are individually a methyl group, an ethyl group, a propyl group, or a tert-butyl group.

In the formulas (1a) to (1h), Y is -N= or -CH=.

As specific examples of the quinoid derivatives, the following compounds can be given.

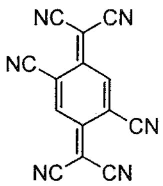
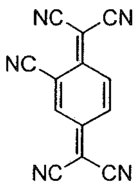
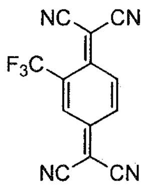
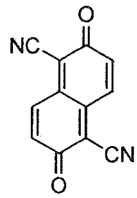
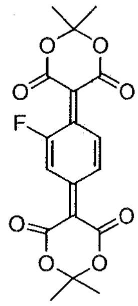

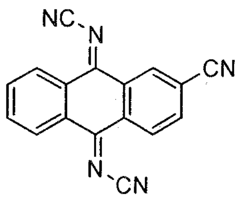
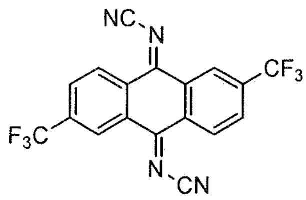
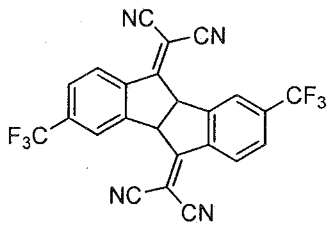

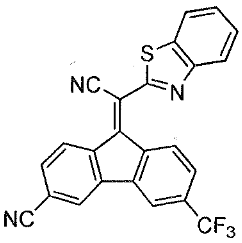
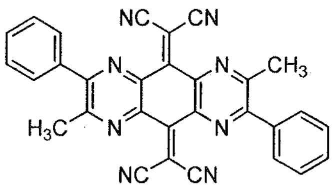
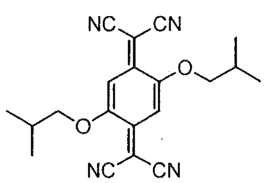

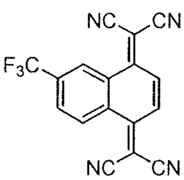
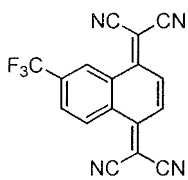
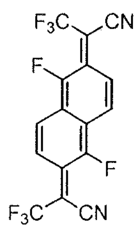
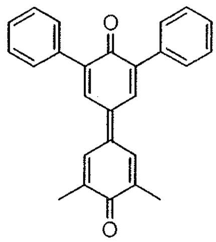

Compounds of the following formula can be given as examples of the arylborane derivatives.

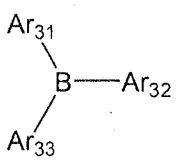

(2a)

In the formula (2a), $Ar_{31}$ to $Ar_{33}$ are individually an aryl group or a heterocyclic ring having an electron-attracting group.

As the aryl group having an electron-attracting group for $Ar_{31}$ to $Ar_{33}$, a pentafluorophenyl group, a heptafluoronaphthyl group, and a pentafluorophenyl group are preferable.

As the heterocyclic ring having an electron-attracting group for $Ar_{31}$ to $Ar_{33}$, a quinoline ring, a quinoxaline ring, a pyridine ring, a pyrazine ring, and the like are preferable.

As specific examples of the arylborane derivatives, the following compounds can be given.

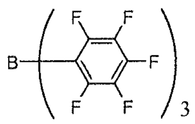
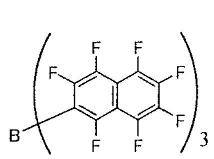
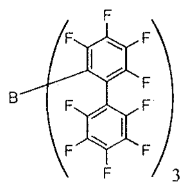
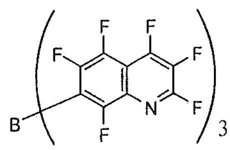

The arylborane derivative is preferably a compound having at least one fluorine as the substituent for the aryl, and particularly preferably tris-β-(pentafluoronaphthyl)borane (PNB).

Compounds of the following formula (3a) can be given as examples of the thiopyran dioxide derivatives, and compounds of the following formula (3b) can be given as examples of the thioxanthene dioxide derivatives.

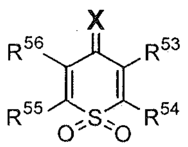
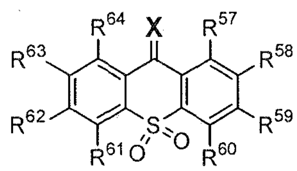

(3a) (3b)

In the formulas (3a) and (3b), $R^{53}$ to $R^{64}$ are individually hydrogen, halogen, a fluoroalkyl group, a cyano group, an alkyl group, or an aryl group. $R^{53}$ to $R^{64}$ are preferably hydrogen or a cyano group.

In the formulas (3a) and (3b), X is an electron-attracting group which is the same as X in the formulas (1a) to (1i). The structures of the formulas (i), (j), and (k) are preferable.

The halogen, fluoroalkyl group, alkyl group, and aryl group for $R^{53}$ to $R^{64}$ are the same as those for $R^1$ to $R^{48}$.

Specific examples of the thiopyran dioxide derivatives of the formula (3a) and the thioxanthene dioxide derivatives of the formula (3b) are given below.

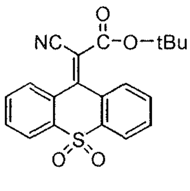
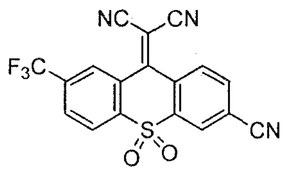
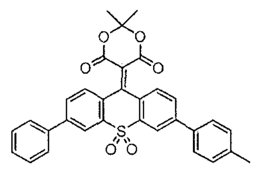

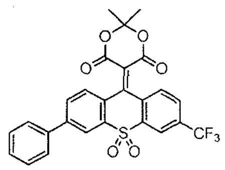 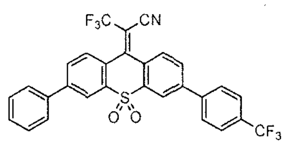

wherein tBu is a t-butyl group.

As the imide derivatives, naphthalenetetracarboxylic acid diimide compounds and pyromellitic acid diimide compounds are preferable.

The compounds of the following formula can be given.

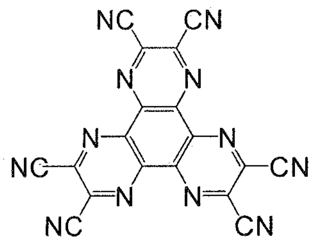

(4) Reducing agent

An emitting layer or a second organic layer which is the organic layer nearest to a cathode preferably contains a reducing agent. The reducing agent is defined as a substance which can reduce an electron transporting compound. Therefore, various substances can be used if they have a certain reducing capability. At least one substance selected from alkali metals, alkaline earth metals, rare earth metals, alkali metal oxides, alkali metal halides, alkaline earth metal oxides, alkaline earth metal halides, rare earth metal oxides or rare metal halides, alkali metal organic complexes, alkaline earth metal organic complexes and rare earth metal organic complexes can be preferably used.

More specifically, preferable reducing agents include at least one alkali metal selected from Na (work function: 2.36 eV), K (work function: 2.28 eV), Rb (work funciton: 2.16 eV) and Cs (work function 1.95 eV); and at least one alkaline earth metal selected from Ca (work function: 2.9 eV), Sr (work function: 2.0 to 2.5 eV) and Ba (work function: 2.52 eV). A substance having work function of 2.9 eV or less is particularly preferable. Of these, a reducing agent is more preferably at least one alkali metal selected from K, Rb and Cs and further more preferably Rb or Cs and most preferably Cs. These alkali metals have particularly high reducing capability. Addition to an electron injecting region in a relatively small amount leads to improvement of luminance and lifetime of an organic EL device. As a reducing agent having work function of 2.9 eV or less, combinations of two ore more alkali metals are preferable, particularly combinations including Cs, such as Cs and Na, Cs and K, Cs and Rb, or Cs, Na and K are preferable. By having Cs in the combination, reducing capability can be given efficiently and the addition to the electron injecting region can lead to improvement of luminance and lifetime of an organic EL device.

In the invention, an electron injecting layer of an insulator and a semiconductor may be further formed between a cathode and an organic layer. By forming the electron injecting layer, a current leakage can be efficiently prevented and electron injecting properties can be improved. As such an insulator, at least one metal compound selected from alkali metal chalcogenides, alkaline earth metal chalcogenides, alkali metal halides and alkali earth metal halides is preferable. If the electron injecting layer is formed of these materials such as alkali metal chalcogenides, the electron injecting properties can be further improved.

Specific examples of preferable alkali metal chalcogenide include $Li_2O$, LiO, $Na_sS$, $Na_2Se$ and NaO; and specific examples of preferable alkaline earth metal chalcogenides include CaO, BaO, SrO, BeO, BaS and CaSe. Examples of preferable alkali metal halides include LiF, NaF, KF, LiCl, KCl and NaCl. Examples of preferable alkaline earth metal halides include fluorides such as $CaF_2$, $BaF_2$, $SrF_2$, $MgF_2$ and $BeF_2$; and halides other than fluorides.

Semiconductors forming an electron transporting layer include one or combinations of two ore more of oxides, nitrides, and oxidized nitrides containing at least one element of Ba, Ca, Sr, Yb, Al, Ga, In, Li, Na, Cd, Mg, Si, Ta, Sb and Zn. An inorganic compound forming an electron transporting layer is preferably a microcrystalline or amorphous insulating thin film. When the electron transporting layer is formed of the insulating thin films, more uniformed thin film

is formed whereby pixel defects such as a dark spot are decreased. Examples of the inorganic compound include the above-mentioned alkali metal chalcogenides, alkaline earth metal chalcogenides, alkali metal halides and alkali earth metal halides.

A full-color emitting apparatus can be produced by combining the organic EL device of the invention and a color filter.

For example, first, second and third organic EL device parts comprising the organic EL device of the invention, which are independently driven, are provided. Color filters transmitting different light (e.g.. red, blue and green color filters) are combined with the device parts, respectively, whereby a full-color emitting apparatus can be obtained. The color filters can receive light of the device parts and the color filters are formed near to the outcoupling side than the device parts. For example, in the case of a bottom-emission type device, color filters may be provided between a transparent electrode layer, which is the undermost layer, and a supporting substrate.

As the color filters, the following dyes only or the dyes in a solid state obtained by dissolving or dispersing a dye in a binder resin may be used.

Red (R) dye: perylene-based pigments, lake-based pigments, azo-based pigments or the like

Green (G) dyes: halogen-polysubstituted phthalocyanine-based pigments, halogen-polysubstituted copper phthalocyanine-based pigments, triphenylmethane-based basic dyes or the like

Blue (B) dyes: copper phthalocyanine-based pigments, indanthrone-based pigments, indophenol-based pigments, cyanine-based pigments or the like

The binder resin is preferably a transparent (50% or more of visible light transmittance) material. Examples include transparent resins (polymer) such as polymethyl methacrylate, polyacrylate, polycarbonate, polyvinyl alcohol, polyvinylpyrrolidone, hydroxyethyl cellulose, and carboxymethyl cellulose. In addition, as photosensitive resins to which the photolithographic method is applied, photo-curable resist materials having a reactive vinyl group such as acrylic acid-based, or methacrylic acid-based reactive vinyl groups may also be used. If the printing method is used, printing ink (medium) using a transparent resin such as polyvinyl chloride resin, melamine resin and phenol resin is used.

When the color filter is formed mainly of a dye, the filter is generally formed through a mask having a pattern of a desired color filter by vacuum deposition or sputtering. When the color filter is formed of a dye and a binder resin, the filter is generally formed as follows. The dye, resin and resist are mixed, dispersed or dissolved, and the mixture is then formed into a film by spin coating, roll coating, casting or by other methods, followed by patterning to a desired color filter pattern by photolithography, printing or the like.

The thickness and transmittance of each of the color filters are preferably as follows.

R: Thickness of 0.5 to 5.0 μm (transmittance of 50% or more/610 nm),

G: Thickness of 0.5 to 5.0 μm (transmittance of 50% or more/545 nm),

B: Thickness of 0.2 to 5.0 μm (transmittance of 50% or more/460 nm)

A sealing layer may be provided between the organic EL device parts and color filters to prevent the organic EL device from being deteriorated by oxygen, moisture and other volatile components contained in the environment or the color filters. The sealing layer may be provided between a transparent electrode layer and color filters, for example. As specific examples of the sealing layer, layers of transparent inorganic compounds such as SiOxNy, AlOxNy and SiAlOxNy may be used and these transparent inorganic compound layers may also be used together with a transparent resin or sealing liquid layer.

A black matrix can be used between the color filters to improve the contrast ratio.

## Examples

The compounds used for Examples and Comparative examples are shown below.

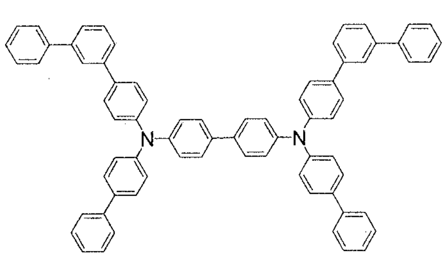

A－2

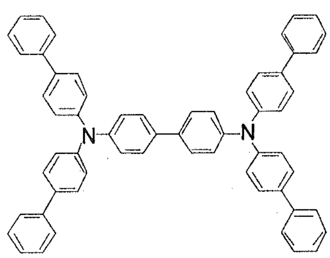

A－１１

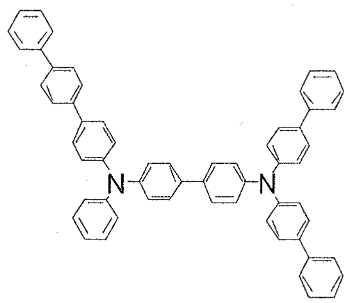

A－１３

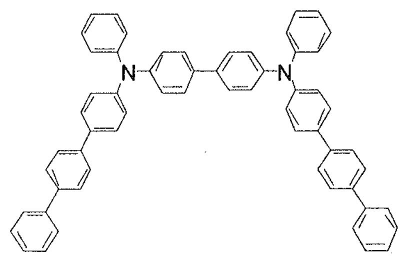

A－１７

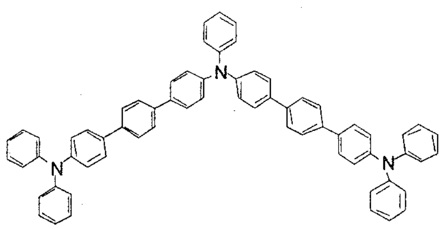

A－３０

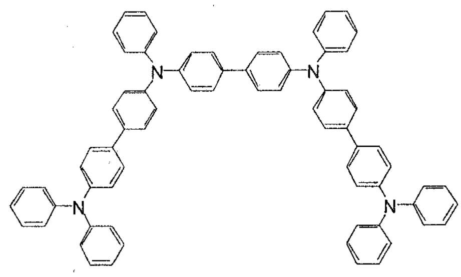

A－３３

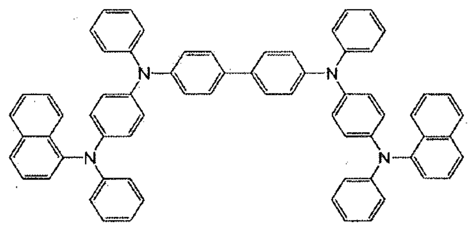

ＨＩ

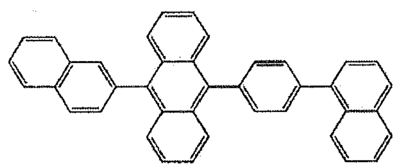

ＢＨ

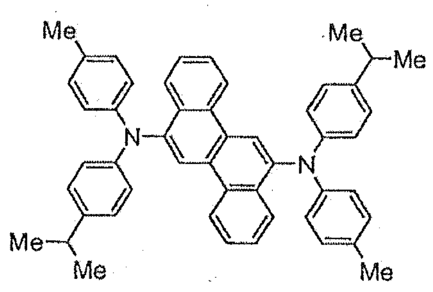

ＢＤ

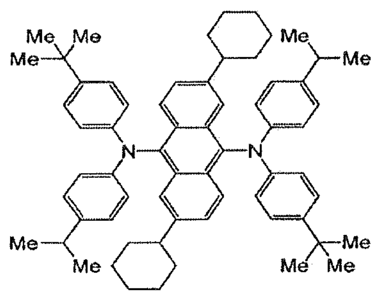

ＧＤ

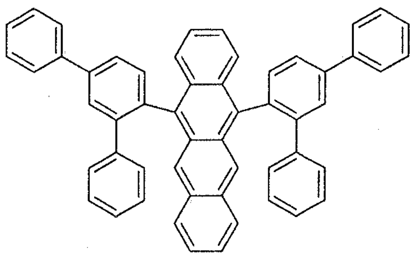

RH

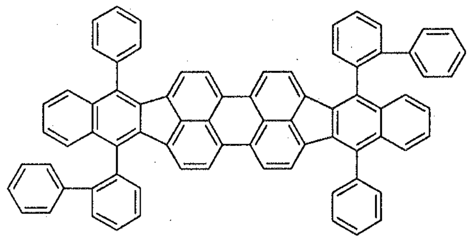

RD

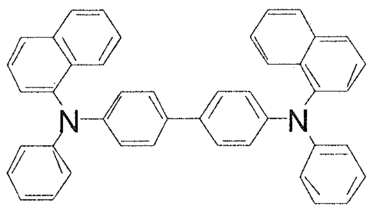

NPD

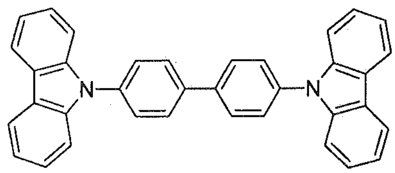

CBP

The properties of the compounds were measured as follows.

(1) Measurement of Tg

The Tg was measured using a DSC "Pyris 1" manufactured by PerkinElmer Inc., and a value obtained by the second heating under the following measurement conditions was taken as the Tg.

<Measurement conditions>

(i) Heating from 30°C to the MAX temperature (10°C/min)
(ii) Holding at the MAX temperature for three minutes
(iii) Cooling from the MAX temperature to -50°C (200°C/min)
(iv) Holding at -50°C for 10 minutes
(v) Heating from -50°C to the MAX temperature (10°C/min)

The MAX temperature was about 30°C plus the melting point at TG-DTA. When the MAX temperature was close to the decomposition temperature, the MAX temperature was corrected correspondingly.

(2) Driving voltage

A voltage (unit: V) which was applied between ITO and Al such that the current density was 10 mA/cm$^2$ was measured.

(3) Luminance efficiency

Luminance efficiency (unit: cd/A) was calculated from an EL spectrum at the current density of 10 mA/cm$^2$ measured with a spectroradiometer (CS-1000A, KONICA MINOLTA, INC.)

(4) CIE 1931 chromaticity

CIE 1931 chromaticity (x, y) was calculated from an EL spectrum at the current density of 10 mA/cm$^2$ measured with a spectroradiometer (CS-1000A, KONICA MINOLTA, INC.

(5) External quantum efficiency

External quantum efficiency was calculated from an EL spectrum at the current density of 10 mA/cm$^2$ measured with a spectroradiometer (CS-1000A, KONICA MINOLTA, INC.) on the basis of the following formula.

$$EQE(\%) = \frac{\int(\int(\text{Spectral radiant intensity / Energy of photon})d\lambda)d\Omega}{\text{Current density / Elementary charge of electron}}$$

λ: wavelength of photon
Ω: solid angle

(6) Measurement of lifetime

The current density of the device at a luminance of 5000 cd/m$^2$ was measured. The device was continuously driven at that current density, and a change in luminance with time was measured using a spectroradiometer CS1000A (manufactured by Konica Minolta). The luminance retention rate with respect to the initial luminance of 5000 cd/m$^2$ after 400 hours of measurement was determined.

Example 1

(Fabrication of organic EL device)

A grass substrate of 25 mm by 75 mm by 1.1 mm thick with an ITO transparent electrode (anode) (GEOMATEC CO., LTD.) (thickness of ITO was 130 nm) was subjected to ultrasonic cleaning with isopropyl alcohol for 5 minutes, and cleaned with ultraviolet rays and ozone for 30 minutes. The resultant substrate with transparent electrode lines was mounted on a substrate holder in a vacuum deposition device. First, an HI film was formed in a thickness of 60 nm so as to cover the surface of the transparent electrode on which the transparent electrode lines were formed. This HI film functioned as a hole-injecting layer. After forming the HI film, an A-11 film was formed in a thickness of 15 nm on the HI film. This A-11 film functioned as a hole-transporting layer.

Following the formation of the A-11 film, RH and RD were deposited to a thickness of 5 nm to form a first emitting layer such that the concentration of RD was 0.5 wt%. The first emitting layer emits red light. Next, as a carrier blocking layer, an A-11 film was formed in a thickness of 5 nm. BH and BD were deposited to a thickness of 40 nm to form a blue emitting layer (second emitting layer) thereon such that the concentration of BD was 7.5 wt%. As an electron-transporting layer, a 20 nm thick tris (8-quinolinol) aluminum film ($Alq_3$ film) was formed thereon. Thereafter, an LiF film was formed in a thickness of 1.6 nm as an electron-injecting layer and metal Al was deposited in a thickness of 150 nm as a metal cathode, thereby fabricating an organic EL device.

(Evaluation of organic EL device)

The properties of the organic EL device obtained were measured. The results were shown in Table 1.

Comparative Example 1

An organic EL device was fabricated in the same way as in Example 1 except that as the carrier blocking layer, an NPD film was formed instead of the A-11 film in a thickness of 5 nm. The measurement results are shown in Table 1.

Comparative Example 2

An organic EL device was fabricated in the same way as in Example 1 except that as the carrier blocking layer, a CBP film was formed instead of the A-11 film in a thickness of 5 nm. The measurement results are shown in Table 1.

Example 2

An organic EL device was fabricated in the same way as in Example 1 except that after forming the second emitting layer in a thickness of 10 nm, as a third emitting layer, BH and GD were deposited to a thickness of 30 nm to form a green emitting layer such that the concentration of GD was 10 wt% and then the $Alq_3$ layer (electron transporting

layer) was formed. The organic EL device obtained was measured in the same way as in Example 1. The results were shown in Table 1.

Comparative Example 3

An organic EL device was fabricated in the same way as in Example 2 except that as the carrier blocking layer, an NPD film was formed instead of the A-11 film in a thickness of 5 nm. The organic EL device obtained was measured in the same way as in Example 1. The results were shown in Table 1.

Comparative Example 4

An organic EL device was fabricated in the same way as in Example 2 except that as the carrier blocking layer, a CBP film was formed instead of the A-11 film in a thickness of 5 nm. The organic EL device obtained was measured in the same way as in Example 1. The results were shown in Table 1.

Example 3

An organic EL device was fabricated in the same way as in Example 2 except that as the carrier blocking layer, an A-2 film was formed instead of the A-11 film in a thickness of 5 nm. The organic EL device obtained was measured in the same way as in Example 1. The results were shown in Table 1.

Example 4

An organic EL device was fabricated in the same way as in Example 2 except that as the carrier blocking layer, an A-13 film was formed instead of the A-11 film in a thickness of 5 nm. The organic EL device obtained was measured in the same way as in Example 1. The results were shown in Table 1.

Example 5

An organic EL device was fabricated in the same way as in Example 2 except that as the carrier blocking layer, an A-17 film was formed instead of the A-11 film in a thickness of 5 nm. The organic EL device obtained was measured in the same way as in Example 1. The results were shown in Table 1.

Example 6

An organic EL device was fabricated in the same way as in Example 2 except that as the carrier blocking layer, an A-30 film was formed instead of the A-11 film in a thickness of 5 nm. The organic EL device obtained was measured in the same way as in Example 1. The results were shown in Table 1.

Example 7

An organic EL device was fabricated in the same way as in Example 2 except that as the carrier blocking layer, an A-33 film was formed instead of the A-11 film in a thickness of 5 nm. The organic EL device obtained was measured in the same way as in Example 1. The results were shown in Table 1.

Example 8

An organic EL device was fabricated in the same way as in Example 1 except that as the carrier blocking layer, A-11 and GD were deposited instead of A-11 to form a layer such that the concentration of GD was 10 wt%, and the thickness of the second emitting layer was changed to 40 nm.
The organic EL device obtained was measured in the same way as in Example 1. The results were shown in Table 1.

Comparative Example 5

An organic EL device was fabricated in the same way as in Example 8 except that as the carrier blocking layer, NPD and GD were deposited instead of A-11:GD to form a layer such that the concentration of GD was 10 wt%.
The organic EL device obtained was measured in the same way as in Example 1. The results were shown in Table 1.
Table 1

| | First emitting layer | Carrier Barrier Layer<br>Tg | Second emitting layer | Third emitting layer | Voltage<br>V | Chromaticity<br>x | Chromaticity<br>y | L/J<br>cd/A | External quantum efficiency<br>% | Luminance retention rate<br>% |
|---|---|---|---|---|---|---|---|---|---|---|
| Example 1 | RH:RD | A-11 135°C | BH:BD | - | 7.2 | 0.27 | 0.26 | 11.6 | 7.6 | 81 |
| Comparative example 1 | RH:RD | NPD 95°C | BH:BD | - | 7.2 | 0.32 | 0.26 | 10.5 | 7.3 | 75 |
| Comparative example 2 | RH:RD | CBP 105°C | BH:BD | - | 7.8 | 0.45 | 0.28 | 12.0 | 6.8 | 70 |
| Example 2 | RH:RD | A-11 135°C | BH:BD | BH:BG | 7.3 | 0.32 | 0.39 | 16.7 | 7.7 | 96 |
| Comparative example 3 | RH:RD | NPD 95°C | BH:BD | EH:BG | 7.3 | 0.36 | 0.40 | 15.7 | 7.3 | 92 |
| Comparative example 4 | RH:RD | CBP 105°C | BH:BD | BH:BG | 7.5 | 0.45 | 0.43 | 15.0 | 7.1 | 83 |
| Example 3 | RH:RD | A-2 123°C | BH:BD | BH:BG | 7.3 | 0.32 | 0.39 | 16.7 | 7.7 | 96 |
| Example 4 | RH:RD | A-13 132°C | BH:BD | BH:BG | 7.3 | 0.32 | 0.39 | 16.7 | 7.7 | 96 |
| Example 5 | RH:RD | A-17 132°C | BH:BD | BH:BG | 7.3 | 0.32 | 0.39 | 16.7 | 7.7 | 96 |
| Example 6 | RH:RD | A-30 137°C | BH:BD | BH:BG | 7.3 | 0.32 | 0.39 | 16.7 | 7.7 | 96 |
| Example 7 | RH:RD | A-33 145°C | BH:BD | BH:BG | 7.3 | 0.32 | 0.39 | 16.7 | 7.7 | 96 |
| Example 8 | RH:RD | A-11:GD 135°C | BH:BD | - | 6.9 | 0.32 | 0.33 | 14.0 | 7.8 | 88 |
| Comparative example 5 | RH:RD | NPD:GD 95°C | BH:BD | - | 6.9 | 0.36 | 0.34 | 13.0 | 7.3 | 80 |

In Example 1, a device configuration was employed in which the red emitting layer and the blue emitting layer were respectively used as the first emitting layer and the second emitting layer, and the carrier blocking layer was inserted between the first emitting layer and the second emitting layer. The aromatic amine compound was used for the carrier blocking layer of Example 1 in the same manner as in Comparative Examples 1 and 2. However, A-11 used in Example 1 has a glass transition temperature (Tg) higher than those of NPD and CBP used in Comparative Example 1 and 2. In Example 1, an excellent white device with an external quantum efficiency higher than those of Comparative Examples 1 and 2 was obtained. The highest luminance retention rate (i.e. long lifetime) was obtained in Example 1 after 400 hours of constant current driving at an initial luminance of 5000 $cd/m^2$.

In Example 2, excellent white light with a high external quantum efficiency was obtained by providing the green emitting layer to the device configuration of Example 1 as the third emitting layer. The luminance retention rate after 400 hours of constant current driving at an initial luminance of 5000 $cd/m^2$ was as high as 96% to achieve a long lifetime.

In Comparative Examples 3 and 4, device configurations were employed in which NPD and CBP with a low Tg were respectively used for the carrier blocking layer of Example 2. The quantum efficiency and the luminance retention rate were lower than those of Example 2 (i.e. short lifetime) (FIG. 3).

In Examples 3 to 7, excellent white light with a high external quantum efficiency was obtained by using the aromatic amine compounds with a high Tg in the same manner as in Example 2. A high luminance retention rate was obtained after 400 hours of constant current driving at an initial luminance of 5000 $cd/m^2$ to achieve a long lifetime.

In Example 8, excellent white light with an equal external quantum efficiency was obtained by doping the carrier blocking layer of Example 1 with the green luminescent material.

In Comparative Example 5, a device configuration was employed in which NPD with a low Tg was used for the carrier blocking layer of Example 8. The quantum efficiency and the luminance retention rate were lower than those of Example 8 (i.e. short lifetime).

Example 9

(Full-color light emitting apparatus)

(1) Formation of color filters

A black matrix (BM) material, V259BK (manufactured by Nippon Steel Chemical Co., Ltd.), was spin-coated on a supporting substrate of 112 mm by 143 mm by 1.1 mm (OA2 glass, manufactured by Nippon Electric Glass Co., Ltd.). The substrate was exposed to ultraviolet rays through a photomask for forming a lattice-like pattern with openings of 68 μm by 285 μm, developed with a 2% aqueous solution of sodium carbonate and baked at 200°C to form a pattern of a black matrix (film thickness 1.5 μm).

Next, a blue filter material, V259B (manufactured by Nippon Steel Chemical Co., Ltd.), was spin-coated. The resultant substrate was exposed to ultraviolet rays through a photomask for forming a pattern of 320 rectangle stripes (100 μm line, 230 μm gap) in alignment with the position of the black matrix, developed with a 2% aqueous solution of sodium carbonate and baked at 200°C to form the pattern (corresponding to a blue pixel) of a blue filter (film thickness 1.5 μm).

Next, a green filter material, V259G (manufactured by Nippon Steel Chemical Co., Ltd.) was spin-coated. The resultant substrate was exposed to ultraviolet rays through a photomask for forming a pattern of 320 rectangle stripes (100 μm line, 230 μm gap) in alignment with the position of the black matrix, developed with a 2% aqueous solution of sodium carbonate and baked at 200°C to form a pattern of a green filter (film thickness 1.5 μm) adjacent the blue filter.

Next, a red filter material, CRY-S840B (manufactured by FUJIFILM Arch Co., Ltd.), was spin-coated. The resultant substrate was exposed to ultraviolet rays through a photomask for forming a pattern of 320 rectangle stripes (100 μm line, 230 μm gap) in alignment with the position of the black matrix, developed with a 2% aqueous solution of sodium carbonate and baked at 200°C to form a pattern of a red filter (film thickness 1.5 μm) between the blue filter and the green filter.

Next, an acrylic thermosetting resin (V259PH, manufactured by Nippon Steel Chemical Co., Ltd.) was spin-coated on the above substrate as a flattening film and baked at 180°C to form a 5 μm-thick flattening film.

(2) Formation of organic EL device

An ITO (indium tin oxide) film was then formed on the flattening film by sputtering in a thickness of 130 nm.

A positive resist (HPR204, manufactured by FIJIFILM OLIN) was spin-coated on the ITO film. The resultant ITO film was exposed to ultraviolet rays through a photomask for forming a stripe-like pattern with a 90 μm line and 20 μm gap and a part for taking out cathode, developed with a developer of tetramethyl ammonium hydroxide, and baked at 130°C to obtain a resist pattern.

Next, ITO in the exposed parts was etched with an ITO etchant. The resist was processed with a release liquid mainly

containing ethanolamine (N303: manufactured by NAGASE & Co., Ltd.) to produce an ITO pattern (lower electrode: anode, 960 lines) in positions corresponding to the blue filter, the green filter and the red filter.

Next, a negative resist (V259PA, manufactured by Nippon Steel Chemical Co., Ltd.) was spin-coated as a first inter-insulating film. The result was exposed to ultraviolet rays through a photomask, developed with a developer of tetramethyl ammonium hydroxide, and baked at 180°C to obtain an inter-insulating film of lattice-like pattern coating edges of ITO. The opening of ITO was 70 μm by 290 μm.

Next, a negative resist (ZPN1100, manufactured by ZEON Corporation) was spin-coated as a second inter-insulating film (separator walls). The result was exposed to ultraviolet rays through a photomask for forming a stripe pattern with a 20 μm line and 310 μm gap, and thereafter baked. The negative resist was developed with a developer of tetramethyl ammonium hydroxide to obtain a second inter-insulating film (separator walls) which runs in a direction perpendicular to the ITO stripes.

The substrate thus obtained was subjected to ultrasonic cleaning with purified water and isopropyl alcohol, dried with air blow and thereafter cleaned with ultraviolet rays.

The organic layers (hole injecting layer to electron injecting layer) were deposited with a mask in the region covering color filters. The cathode was deposited with a mask so as to connect with an electrode for taking out ITO, which electrode had been previously formed. The organic layers and cathode were formed in the same manner as in Example 2.

The cathode (upper electrode) was automatically separated by the separator walls that had been formed on the substrate to form a pattern intersecting lower electrodes (240 lines).

The substrate with the organic EL element thus formed thereon was moved in a dry box through which dried nitrogen flowed without contacting the atmosphere. In this dry box, a display part was covered with a sealing substrate of glass plate and a cation curable adhesive (TB3102, manufactured by Three Bond Co., Ltd.) was photo-cured in the periphery of the display part for sealing.

As stated above, a full-color emission apparatus was produced where lower and upper electrodes formed an XY matrix. When a DC voltage was applied across the lower and upper electrodes (lower electrode: (+), upper electrode: (-)), the intersections of electrodes (pixels) each emitted light.

(3) Evaluation of properties of full-color emitting apparatus

(Blue color performance)

As a result of application of a DC voltage of 7.25 V between the lower electrode and the upper transparent electrode corresponding to the blue filter, blue emission was obtained. The blue emission was measured by means of a spectroradiometer (CS-1000, manufactured by Konica Minolta Holdings, Inc.), and as a result, it was found that the luminance was 31 cd/$m^2$ and the chromaticity coordinates were (0.124, 0.117). The luminous efficiency was calculated by measuring the value of current flowing between these electrodes, and found to be 1.14 cd/A.

(Green color performance)

As a result of application of a DC voltage of 7.25 V between the lower electrode and the upper transparent electrode corresponding to the green filter, green emission was obtained. The green emission was measured by means of a spectroradiometer (CS-1000, manufactured by Konica Minolta Holdings, Inc.), and as a result, it was found that the luminance was 250 cd/$m^2$ and the chromaticity coordinates were (0.247, 0.621). The luminous efficiency was calculated by measuring the value of current flowing between these electrodes, and found to be 9.24 cd/A.

(Red color performance)

As a result of application of a DC voltage of 7.25 V between the lower electrode and the upper transparent electrode corresponding to the red filter, red emission was obtained. The red emission was measured by means of a spectroradiometer (CS-1000, manufactured by Konica Minolta Holdings, Inc.), and as a result, it was found that the luminance was 85 cd/$m^2$ and the chromaticity coordinates were (0.652, 0.335). The luminous efficiency was calculated by measuring the value of current flowing between these electrodes, and found to be 3.15 cd/A.

(4) Entire surface lightening

As a result of application of a DC voltage of 7.25 V between all lower electrodes and all upper electrodes, white emission was observed. The white emission was measured by means of a spectroradiometer (CS-1000, manufactured by Konica Minolta Holdings, Inc.), and as a result, it was found that the luminance was 451 cd/$m^2$ and the chromaticity

coordinates were (0.324, 0.397). The luminous efficiency was calculated by measuring the value of current flowing between these electrodes, and found to be as high as 4.51 cd/A.

Industrial Applicability

The organic EL device of the invention can be used for various displays, backlight, full-color displays with color filters, and light sources for general and special lighting.

## Claims

1. An organic electroluminescent device comprising:

an anode, a first emitting layer, a carrier blocking layer, a second emitting layer and a cathode in that order;
the carrier blocking layer comprising an aromatic amine derivative having a glass transition temperature of more than 110°C represented by the following formula (1);

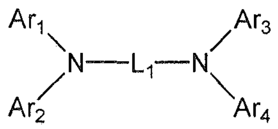
(1)

wherein $L_1$ is a divalent group of a substituted or unsubstituted arylene group with 5 to 60 carbon atoms, or a substituted or unsubstituted heterocyclic group;
$Ar_1$ is a substituted or unsubstituted substituent with 10 to 50 ring atoms, or a substituent represented by the following formula (2); and
$Ar_2$ to $Ar_4$ are each a substituted or unsubstituted substituent with 5 to 50 ring atoms or a substituent represented by the following formula (2), provided that $Ar_1$ to $Ar_4$ are not condensed rings;

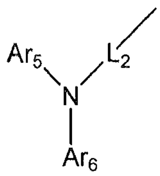
(2)

wherein $L_2$ is a divalent group of a substituted or unsubstituted arylene group with 5 to 60 carbon atoms or a substituted or unsubstituted heterocyclic group, and
$Ar_5$ to $Ar_6$ are each a substituted or unsubstituted substituent with 5 to 50 ring atoms, provided that $Ar_5$ to $Ar_6$ are not condensed rings.

2. The organic electroluminescent device according to claim 1 wherein $L_1$ and $L_2$ are biphenylene, terphenylene, phenanthrene or a substituted or unsubstituted fluorenylene in the formula (1).

3. The organic electroluminescent device according to claim 1 or 2 wherein $Ar_1$ is a biphenyl group, m-terphenyl group, or p-terphenyl group; and
$Ar_2$ to $Ar_6$ are a phenyl group, biphenyl group, m-terphenyl group, or p-terphenyl group, in the formula (1).

4. The organic electroluminescent device according to any one of claims 1 to 3 wherein $Ar_1$ to $Ar_4$ are the same substituents in the formula (1).

5. The organic electroluminescent device according to any one of claims 1 to 3 wherein $Ar_2$ to $Ar_4$ of $Ar_1$ to $Ar_4$ are the same substituents in the formula (1).

6. The organic electroluminescent device according to any one of claims 1 to 3 wherein 3 or more of $Ar_1$ to $Ar_4$ are

different substituents.

**7.** The organic electroluminescent device according to any one of claims 1 to 6 wherein the carrier blocking layer comprises an emitting material.

**8.** The organic electroluminescent device according to any one of claims 1 to 7 further comprising a hole transporting layer adjacent to the first emitting layer between the anode and the first emitting layer,
a material forming the hole transporting layer being the same as a material forming the carrier blocking layer.

**9.** The organic electroluminescent device according to any one of claims 1 to 8 wherein the first emitting layer is a red emitting layer and the second emitting layer is a blue emitting layer.

**10.** The organic electroluminescent device according to any one of claims 1 to 9 further comprising a third emitting layer between the second emitting layer and the cathode,
the anode, first emitting layer, carrier blocking layer, second emitting layer, third emitting layer and cathode being stacked in that order.

**11.** The organic electroluminescent device according to claim 10 wherein the first emitting layer is a red emitting layer, the second emitting layer is a blue emitting layer and the third emitting layer is a green emitting layer.

**12.** The organic electroluminescent device according to any one of claims 1 to 11 wherein the first emitting layer or a first organic layer that is the organic layer closer to the anode comprises an oxidizing agent.

**13.** The organic electroluminescent device according to any one of claims 1 to 12 wherein the second emitting layer or a second organic layer that is the organic layer closer to the cathode comprises a reducing agent.

**14.** A full-color emitting apparatus comprising the organic electroluminescent device according to any one of claims 1 to 13 and a color filter.

FIG.1

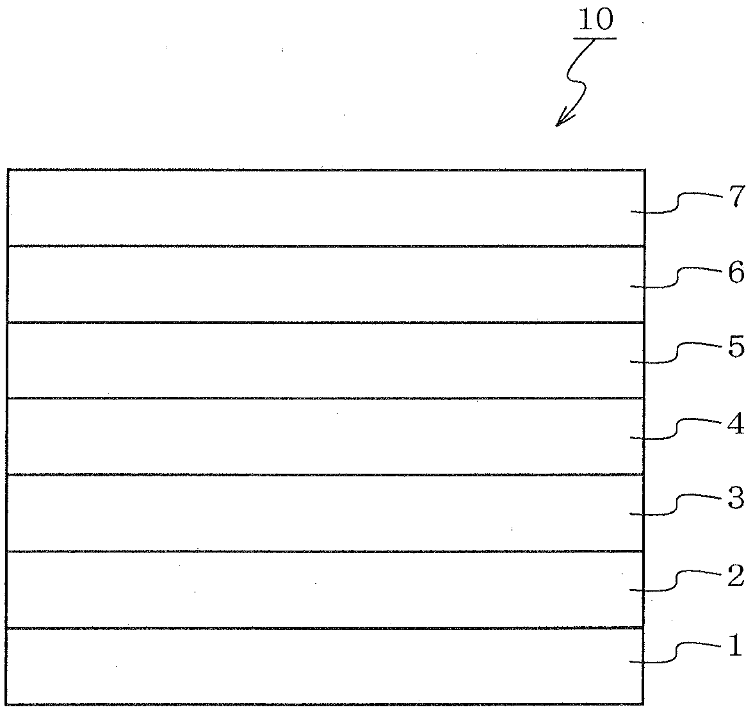

FIG.2

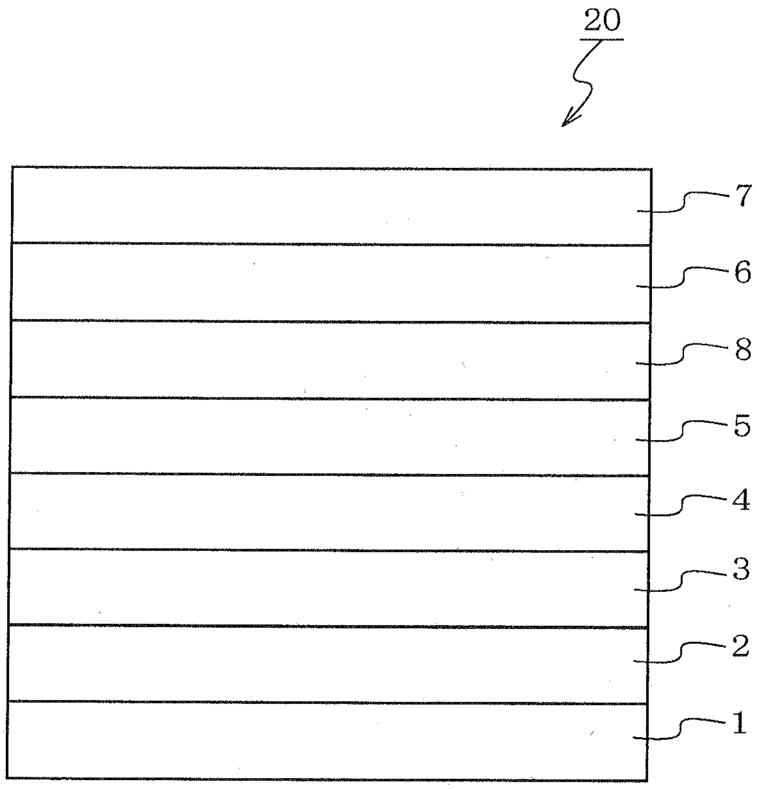

FIG. 3

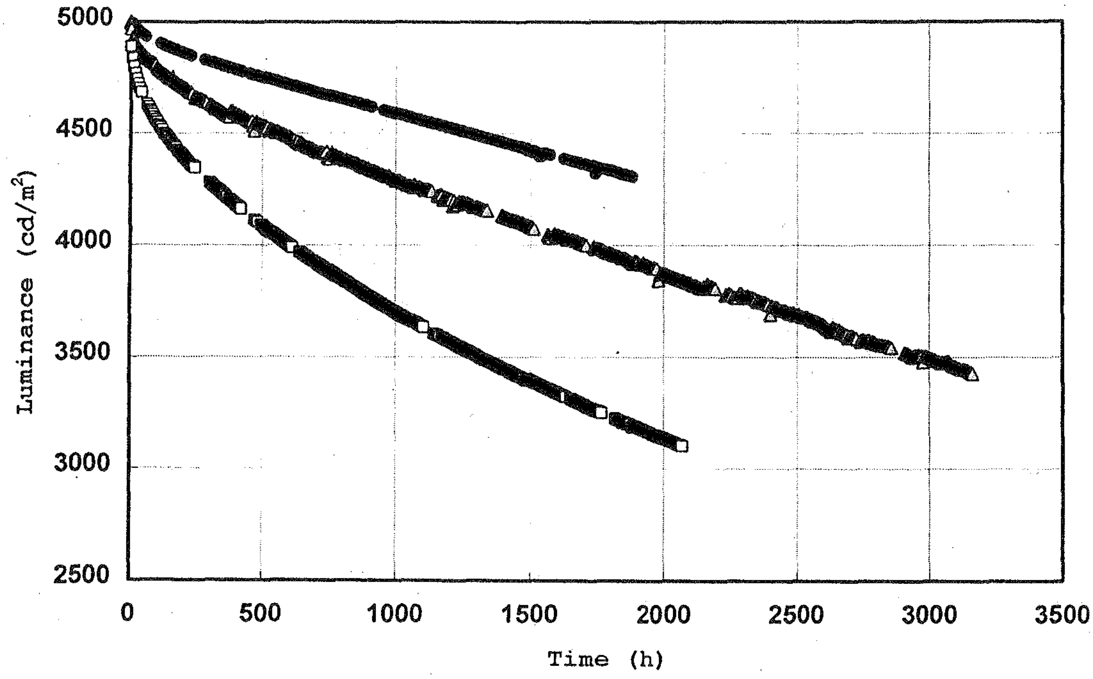


● Example 2

△ Comparative example 3

□ Comparative example 4

**INTERNATIONAL SEARCH REPORT**

International application No.
PCT/JP2007/065916

A. CLASSIFICATION OF SUBJECT MATTER
*H01L51/50*(2006.01)i, *C09K11/06*(2006.01)i, *H05B33/12*(2006.01)i

According to International Patent Classification (IPC) or to both national classification and IPC

B. FIELDS SEARCHED

Minimum documentation searched (classification system followed by classification symbols)
H01L51/50-51/56, C09K11/06, H05B33/00-33/28

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)
Scitation

C. DOCUMENTS CONSIDERED TO BE RELEVANT

| Category* | Citation of document, with indication, where appropriate, of the relevant passages | Relevant to claim No. |
|---|---|---|
| Y | WO 2005/099313 A1 (IDEMITSU KOSAN CO., LTD.), 20 October, 2005 (20.10.05), Abstract; Par. Nos. [0002], [0013] to [0017], [0030], [0073] to [0076], [0109] to [0113] (Family: none) | 1-14 |
| Y | WO 2005/112518 A1 (IDEMITSU KOSAN CO., LTD.), 24 November, 2005 (24.11.05), Abstract; Par. Nos. [0019], [0031], [0083], [0088] & EP 001729544 A1 | 1-14 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 02 October, 2007 (02.10.07) | 16 October, 2007 (16.10.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2007/065916

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2005-100921 A (Sony Corp.),<br>14 April, 2005 (14.04.05),<br>Par. Nos. [0047] to [0051], [0067] to [0079];<br>Figs. 1 to 4, 6<br>& US 2006/0227079 A & EP 001667494 A<br>& WO 2005/027586 A1 | 1-14 |
| Y | Shizuo TOKITO (et al.), "Yuki Denkai Hakko Soshi", R&D Review of Toyota CRDL, 1998.06, Vol.33, No.2, pages 3 to 22 | 1-3,5-6 |
| Y | JP 8-048656 A (TDK Corp.),<br>20 February, 1996 (20.02.96),<br>Abstract; Par. Nos. [0104] to [0108], [0270] to [0273]<br>& JP 2006-173652 A & JP 2006-206596 A<br>& US 005792557 A & EP 000666298 A2 | 1-6 |
| A | WO 2006/070619 A1 (Konica Minolta Holdings, Inc.),<br>06 July, 2006 (06.07.06),<br>Abstract; Par. Nos. [0286] to [0300]<br>(Family: none) | 1 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2003272857 A
- JP 2004235168 A
- JP 8078163 A
- WO 2005099313 A
- WO 2005112518 A
- JP 2005100921 A
- US 20060088729 A
- JP 57051781 A
- US 3112197 A
- US 3189447 A
- JP 3716096 B
- US 3615402 A
- US 3820989 A
- US 3542544 A
- JP 45555 B
- JP 51010983 B
- JP 51093224 A
- JP 55017105 A
- JP 56004148 A
- JP 55108667 A
- JP 55156953 A
- JP 56036656 A
- US 3180729 A
- US 4278746 A
- JP 55088064 A
- JP 55088065 A
- JP 49105537 A
- JP 55051086 A
- JP 56080051 A
- JP 56088141 A
- JP 57045545 A
- JP 54112637 A
- JP 55074546 A
- US 3615404 A
- JP 51010105 B
- JP 46003712 B
- JP 47025336 B
- JP 54119925 B
- US 3567450 A
- US 3240597 A
- US 3658520 A
- US 4232103 A
- US 4175961 A
- US 4012376 A
- JP 49035702 B
- JP 3927577 B
- JP 55144250 A
- JP 56119132 A
- JP 56022437 A
- DE 1110518
- US 3526501 A
- US 3257203 A
- JP 56046234 A
- JP 54110837 A
- US 3717462 A
- JP 54059143 A
- JP 55052063 A
- JP 55052064 A
- JP 55046760 A
- JP 57011350 A
- JP 57148749 A
- JP 2311591 A
- JP 61210363 A
- JP 61228451 A
- JP 61014642 A
- JP 61072255 A
- JP 62047646 A
- JP 62036674 A
- JP 62010652 A
- JP 62030255 A
- JP 60093455 A
- JP 60094462 A
- JP 60174749 A
- JP 60175052 A
- US 4950950 A
- JP 2204996 A
- JP 2282263 A
- JP 63295695 A
- US 4127412 A
- JP 53027033 A
- JP 54058445 A
- JP 55079450 A
- JP 61295558 A
- JP 61098353 A
- US 5061569 A
- JP 4308688 A
- JP 8193191 A
- JP 2003004193 A
- JP 9087616 A
- JP 9194487 A
- JP 2000040586 T
- JP 10088121 A